# EUROPÄISCHE PATENTSCHRIFT

(11) **EP 3 546 967 B1**
(45) Veröffentlichungstag und Bekanntmachung des Hinweises auf die Patenterteilung: **23.11.2022**
(21) Anmeldenummer: 18164019.4
(22) Anmeldetag: 26.03.2018
(51) Int. Cl.: G01R 33/3415, G01R 33/36, G01R 33/561

(54) **LOKALSPULENMATRIX UND VERFAHREN ZUR BILDERFASSUNG**
LOCAL COIL MATRIX AND METHOD FOR IMAGING
MATRICE DE BOBINE LOCAL ET PROCÉDÉ DE DÉTECTION D'IMAGES

(43) Veröffentlichungstag der Anmeldung: 02.10.2019
(73) Patentinhaber: Siemens Healthcare GmbH, 91052 Erlangen (DE)
(72) Erfinder: Popescu, Stefan, 91056 Erlangen (DE)

(56) Entgegenhaltungen:
- EP-A1- 0 280 908
- DE-A1- 10 308 961
- DE-A1-102006 055 136
- US-A1- 2005 134 271
- US-A1- 2007 038 068
- US-A1- 2015 323 624

## Beschreibung

Die Erfindung betrifft ein Verfahren zur Bilderfassung mit einem Magnetresonanztomographen mit einer Lokalspulenmatrix.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, auch als Magnetresonanzsignal bezeichnet, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Die erzeugte Darstellung gibt eine räumliche Dichteverteilung der Spins an.

Die Magnetresonanzsignale aus dem Körper des Patienten stammen dabei aus Bereichen mit unterschiedlichen Bedingungen. Während einige Bereiche weitgehend homogen sind, z.B. Fettgewebe und große Muskeln wie am Oberschenkel, sind andere Bereiche wie Handgelenk oder Herzkranzgefäße fein strukturiert und aus Geweben mit unterschiedlichen Eigenschaften. Zum einen werden dadurch unterschiedliche Anforderungen an eine homogene Anregung der Kernspins gestellt, zum anderen sind auch bei der Erfassung und Auswertung der Magnetresonanzsignale Anpassungen und Optimierungen denkbar.

Aus dem Dokument EP 0 280 908 A1 ist eine Oberflächenspule Bestehend aus mehreren Leiterabschnitten bekannt, die über Schalter so miteinander und mit der Abstimmeinheit verbindbar sind, dass die je nach Stellung der Schalter mit der Abstimmeinheit verbundenen Leiterabschnitte unterschiedliche Flächen einschließen. Damit kann die wirksame Fläche der Oberflächenspule durch entsprechende Stellung der Schalter an die jeweiligen Erfordernisse angepasst werden.

Das Dokument DE 10 2006 055136 A1 beschreibt eine Hochfrequenzspulenanordnung umfassend mehrere Grundspulen bildende Leiterbahnen mit darin verschalteten Kapazitäten, wobei sich Leiterbahnen verschiedener Grundspulen an Knotenpunkten überschneiden, wobei zumindest an einem Teil der Knotenpunkte wenigstens ein Schaltmittel zur selektiven, reversiblen Verbindung der Leiterbahnen zur Bildung unterschiedlicher Spulengeometrien vorgesehen ist.

Aus dem Dokument DE 103 08 961 A1 ist es zum Zweck der Änderung der Geometrie und des Abstands zwischen Schleifenspulen, die in einer RF-Spule enthalten sind, bekannt, ohne Bewegung der RF-Spule Schleifen mit einer für Quadratsummenverfahren unter Verwendung eines phasengesteuerten Arrays optimierten Geometrie und zweite kleine Schleifen mit einer für ein Empfindlichkeitskodierverfahren optimierten Geometrie durch Schaltelemente für eine Öffnen-/Schließen-Operation unter Verwendung einer Diode umzuschalten, wobei erste Entkopplungseinrichtungen und zweite Entkopplungseinrichtungen umgeschaltet werden.

Das Dokument US 2015/323624 A1 beschreibt ein Verfahren und eine Vorrichtung zum Empfang von Magnetresonanzsignalen mit Antennenspulen, die überlappend und/oder konzentrisch angeordnet sind. Die Antennenspulen sind operational unterschiedlich groß und/oder in unterschiedlichem Abstand zum Patienten angeordnet, um Signale von andernfalls miteinander verkoppelten Spulen mit einem verbesserten SNR in der Bildgebung zu erzielen.

Aus dem Dokument US 2005/134271 A1 ist eine Kniespule mit einer phasengekoppelten Spulenmatrix bekannt, die ein e Sendematrix und eine Empfangsmatrix mit einer Vielzahl an Spulen aufweist, die ausgelegt sind, einen ersten und einen Zweiten Bilderfassungsmodus bereitzustellen.

Das Dokument US 2007/0038068 A1 beschreibt schließlich ein Verfahren, um eine Abbildung eines Körperteils in einem Magnetresonanztomographen zu erzeugen. Kernspins werden mittels Gradienten- und/oder Hochfrequenzpulsen angeregt. Anschließend werden Magnetresonanzsignale mittels einer Spulenanordnung aufgezeichnet, wobei eine Anzahl an Spulenelementen individuell aktiviert werden kann. Anschließend werden Abbildungen aus den aufgezeichneten Signalen rekonstruiert. Die räumliche Empfindlichkeitsverteilung wird mittels geeigneter Aktivierung der Spulenmatrix bei der Anregung und/oder dem Empfang variiert.

Es ist daher eine Aufgabe der vorliegenden Erfindung, eine Lokalspule und ein Verfahren zur Bilderfassung damit bereitzustellen, mit dem eine bessere und effizientere Bilderfassung möglich ist.

Die Aufgabe wird durch das Verfahren nach Anspruch 1 und 2 gelöst.

In dem erfindungsgemäßen Verfahren zur Bilderfassung mit einem Magnetresonanztomographen mit einer Lokalspulenmatrix weist die Lokalspulenmatrix eine Steuerung in Signalverbindung mit Verstimmungselementen oder Spulensegmente und Koppelelemente in Signalverbindung mit der Steuerung auf.

In einem Schritt des Verfahrens sendet der Magnetresonanztomograph einen ersten Anregungspuls aus. Der Anregungspuls ist dabei ausgelegt, Kernspins in einem Untersuchungsobjekt in dem Magnetresonanztomographen anzuregen. Der Anregungspuls kann beispielsweise über eine Körperspule oder auch eine Lokalspule, beispielsweise die zweiten Spulenwicklungen der Lokalspulenmatrix ausgesendet werden. Dabei ist eine erste Menge an ersten Spulenwicklungen resonant zur Frequenz des Anregungspulses. Dies kann beispielsweise durch eine Konfiguration der Verstimmungselemente bei ersten Spulenwicklungen oder durch Schließen von Koppelelementen erfolgen, die so aus Spulensegmenten eine erste oder zweite Spulenwicklung ausbilden. Aufgrund der Resonanz und der Anordnung können dabei die ersten Spulenwicklungen das von dem Anregungspuls erzeugte B1-Feld abschwächen oder verstärken, wobei der Effekt und die Stärke von der Resonanzfrequenz der ersten Spulenwicklung abhängt. Die Anregung kann dabei gesteuert durch Frequenz, Gradientenfelder und auch Position der ausgewählten Sendeantennen auch nur in bestimmten Bereichen des Patienten erfolgen.

In einem anderen Schritt des Verfahrens werden die angeregten Spins mittels der Gradientenspulen phasenkodiert, um den Kernspins eine räumliche Position aufzuprägen.

In einem weiteren Schritt werden Magnetresonanzsignale mittels einer zweiten Menge an ersten Spulenwicklungen und/oder zweiten Spulenwicklungen empfangen, d.h. einzeln oder kombiniert einem Empfänger des Magnetresonanztomographen zu weiteren Verarbeitung und einer Bilderfassung zugeführt.

In einem anderen Schritt erfolgt ein Aussenden eines zweiten Anregungspulses zur Anregung der Kernspins. Diese Anregung unterscheidet sich dadurch, dass eine dritte Menge an ersten Spulenwicklungen resonant zur Frequenz des Anregungspulses ist. Dabei unterscheidet sich die dritte Menge von der ersten Menge, sodass zumindest eine der ersten Spulenwicklungen im Vergleich zur ersten Anregung in einem anderen Zustand (resonant/nicht-resonant) ist. Dabei ist es auch denkbar, dass beispielsweise durch ein anderes z-Gradientenfeld auch Kernspins in einem anderen Bereich des Patienten angeregt werden. Die unterschiedlichen resonanten ersten Spulenwicklungen der dritten Menge passen bei dieser Anregung das Bl-Shimming einer anderen Situation, beispielsweise einer anderen Schicht in z-Richtung an. Es ist aber auch denkbar, dass in dem gleichen Bereich durch das veränderte Bl-Shimming beispielsweise auf eine Bewegung des Patienten reagiert wird.

Auch auf die zweite Anregung erfolgt in einem weiteren Schritt ein räumliches Codieren der Spins mittels der Gradientenspulen.

In einem weiteren Schritt werden Magnetresonanzsignale mittels einer vierten Menge an ersten Spulenwicklungen und/oder zweiten Spulenwicklungen empfangen. Dabei ist es in einer nicht beanspruchten Variante denkbar, dass die vierte Menge gleich der zweiten Menge ist, wenn mit einem üblichen Verfahren, d.h. ohne Unterabtastung Magnetresonanzsignale aus dem gleichen Bereich wie beim vorhergehenden Empfangen werden sollen. Denkbar ist aber auch, dass beispielsweise eine andere Schicht in z-Richtung abgetastet wird. Erfindungsgemäß ist die zweite Menge ungleich der vierten Menge, d.h. das Empfangen erfolgt mit einer anderen Kombination aus ersten Spulenwicklungen und zweiten Spulenwicklungen mit unterschiedlichem räumlichem Sensitivitätsbereich, um unterabgetastete Signale für eine Bilderfassung mit Compressed Sensing bereitzustellen.

Auf vorteilhafte Weise erlaubt es das erfindungsgemäße Verfahren, ein dynamisches, räumlich variables Bl-Shimming mittels der ersten Spulenwicklungen bereitzustellen.

Dabei ist es auch denkbar, dass der Schritt des Empfangens von Kernresonanzsignalen nicht unmittelbar auf den Schritt des Anregens und Codierens erfolgt. Zur Beschleunigung, beispielsweise mittels eines Multi-Slice-Verfahrens, ist es dabei denkbar, dass mehrere Abfolgen aus Anregung und Auslesen miteinander zeitlich verschachtelt sind, sodass auf das Anregen von Kernspins in einem Teilbereich des Untersuchungsbereichs zunächst das Auslesen in einem anderen Teilbereich des Untersuchungsbereichs erfolgt, der bereits vorher angeregt wurde. Die Lokalspulenmatrix ist dabei sowohl im Sende- als auch im Empfangsschritt in der Lage, die Auswahl der Spulenwicklung zu ändern und so jeweils unterschiedliche und optimal angepasste Anregungs- und/oder Sensitivitätsmuster zu verwenden.

Auf vorteilhafte Weise ermöglicht die Lokalspulenmatrix ein erfindungsgemäßes Verfahren zur Bilderfassung, das den Bilderfassungsvorgang beschleunigt und dennoch optimale Bildqualität liefert.

Die nicht beanspruchte Lokalspulenmatrix weist eine Mehrzahl an Spulenwicklungen auf. Als Spulenwicklungen werden dabei Antennenspulen bezeichnet, die ausgelegt sind, hochfrequente magnetische Wechselfelder, insbesondere durch Kernspins erzeugt, zu erfassen und in elektrische Signale für eine Bilderfassung zu wandeln oder zur Anregung von Kernspins auszusenden. Denkbar ist dabei auch, dass die Spulenwicklung beim Sendefall passiv durch ein extern erzeugtes hochfrequentes magnetisches Wechselfeld angeregt wird. Die Spulenwicklung kann eine oder mehrere Windungen aufweisen. Die Lokalspulenmatrix ist dabei ausgelegt, bei einer Magnetresonanztomographie einen vorbestimmten Bereich eines in Nachbarschaft zu der Lokalspule angeordneten Patienten mit auswählbaren unterschiedlich großen Sensitivitätsbereichen erfassen zu können. Als Sensitivitätsbereich wird dabei der Bereich im Raum bezeichnet, indem die Spulenwicklung nur eine geringe Abnahme der durch ein magnetisches Wechselfeld induzierten Spannung bzw. Strom gegenüber einer Magnetfeldquelle im Mittelpunkt einer von der Spulenwicklung umschlossenen Fläche aufweist. Dabei kann es auch vorgesehen sein, dass beispielsweise die Anzahl der Windungen oder unterschiedliche Vorverstärkerempfindlichkeiten (Amplitude und Phase), die unabhängig von der Geometrie bzw. Form der Spule sind, aus der Sensitivität der jeweiligen Spule herausgerechnet werden. Als geringe Abnahme im Sinne der Erfindung kann eine Dämpfung von weniger als 6 dB, 12 dB, 18 dB oder 24 dB angesehen werden. Dies wird, wie in den nachfolgenden unabhängigen Ansprüchen näher ausgeführt, erreicht, indem Spulenwicklungen mit unterschiedlichen Abmessungen, insbesondere umschlossenen Flächen zum Empfang der magnetischen Felder für den Empfang konfigurierbar sind.

Auf vorteilhafte Weise ermöglicht es die Lokalspulenmatrix, ein magnetisches Wechselfeld mit unterschiedlichen auswählbaren Sensitivitätsbereichen zu detektieren und so mit den nachfolgend beschriebenen Verfahren eine Bilderfassung zu beschleunigen und/oder zu verbessern.

In einer nicht beanspruchten Variante weist die Lokalspulenmatrix eine erste Spulenwicklung und eine zweite Spulenwicklung auf.

Die erste Spulenwicklung weist einen ersten Sensitivitätsbereich auf und die zweite Spulenwicklung einen zweiten Sensitivitätsbereich. Die unterschiedlichen Sensitivitätsbereiche können beispielsweise durch unterschiedliche Geometrien wie unterschiedlicher Durchmesser bzw. Umfang der Spulenwicklungen gegeben sein. Dabei ist der erste Sensitivitätsbereich eine Teilmenge des zweiten Sensitivitätsbereiches. Mit anderen Worten, der Bereich gleicher Empfindlichkeit bzw. Sensitivität auf ein magnetisches Wechselfeld der ersten Spulenwicklung ist kleiner als der der zweiten Spulenwicklung und in diesem im Wesentlichen erhalten. Das kann beispielsweise der Fall sein, wenn die erste Spulenwicklung eine kleinere Fläche umschließt als die zweite Spulenwicklung.

Zusätzlich müssen die Spulenwicklungen geeignet zueinander angeordnet sein, beispielsweise wenn sie co-planar in benachbarten Ebenen derart angeordnet sind, dass die Projektion entlang der Flächennormalen der zweiten Spulenwicklung auf die erste Spulenwicklung diese umfasst, d.h. im Wesentlichen vollständig abdeckt. Als benachbart kann dabei ein Abstand angesehen werden, der kleiner als ein 0,1 faches, 0,2 faches oder 0,5 faches des Durchmessers bzw. der größten Abmessung der ersten Spulenwicklung ist. Es kann aber sein, dass beispielsweise zur Entkopplung von benachbarten ersten Spulen ein Überlapp vorhanden ist, der dann nicht durch die Projektion der Fläche der zweiten Spule abgedeckt ist, was durch den Begriff "im Wesentlichen" zum Ausdruck gebracht werden soll.

Im Übrigen ist es auch denkbar, dass mehrere Größenklassen von Spulenwicklungen kaskadiert werden, sodass zwischen den ersten Spulenwicklungen und den zweiten Spulenwicklungen eine weitere Klasse von Spulenwicklungen vorgesehen ist, die größere Abmessungen als die ersten Spulenwicklungen abdeckt und zu diesen in einem Verhältnis wie die zweiten Spulenwicklungen steht, während die weitere Klasse an Spulenwicklungen wiederum kleiner ist als die zweiten Spulenwicklungen, von diesen im Sensitivitätsbereich umfasst wird und in einem Verhältnis zu den zweiten Spulenwicklungen wie die ersten Spulenwicklungen steht.

Indem die Lokalspulenmatrix die zu erfassende Fläche mit Spulenwicklungen unterschiedlicher Größe abdeckt, kann für die Untersuchung auf vorteilhafte Weise ohne Wechsel der Lokalspulenmatrix eine Spulenwicklung mit am besten geeigneten Größe des Sensitivitätsbereichs gewählt werden und so die Bildqualität optimiert werden.

Im Rahmen des in Anspruch 1 definierten Verfahrens weist die Lokalspulenmatrix eine Mehrzahl an ersten Spulenwicklungen auf. Die einzelnen ersten Spulenwicklungen weisen jeweils erste Sensitivitätsbereiche auf. Es ist beispielsweise denkbar, dass die ersten Spulenwicklungen co-planar in einer Fläche in einem Gitter oder Matrix angeordnet sind. Die Matrix bzw. das Gitter kann dabei auch nur teilweise besetzt sein, sodass Lücken zwischen den Sensitivitätsbereichen der ersten Spulenwicklungen bestehen. Eine zweite Spulenwicklung kann dann dazu in einer im wesentlichen parallelen Ebene in einem geringen Abstand, z.B. kleiner als der Durchmesser der ersten Spulenwicklungen, so angeordnet sein, dass die Projektion der ersten Spulenwicklungen auf die zweite Spulenwicklung die von der zweiten Spulenwicklung umschlossene Fläche zumindest teilweise abdecken. Mit anderen Worten, zumindest in einem Bereich in der Nähe der ersten Spulenwicklungen, die durch deren Sensitivitätsbereich definiert ist, insbesondere dessen Tiefe senkrecht zu der von der ersten Spulenwicklung umschlossenen Fläche, decken die ersten Spulenwicklungen den Bilderfassungsbereich der zweiten Spulenwicklung teilweise ab. Beispielsweise kann bei einer Matrixanordnung nur jeder zweite Gitterplatz mit einer ersten Spulenwicklung besetzt sein oder eine andere, auch unregelmäßige Anordnung vorgesehen sein, sodass die Projektionen der Sensitivitätsbereiche der ersten Spulenwicklungen auf die Fläche der zweiten Spulenwicklung deren Fläche zu mehr als 20%, 50% oder 80% abdecken.

So ermöglicht die Lokalspulenmatrix eine Unterabtastung mit unterschiedlichen Auflösungen, wie sie nachfolgend zu den Verfahren beschrieben ist, eine Magnetresonanzdarstellung eines Patienten schneller zu erfassen.

Im Rahmen des in Anspruch 1 definierten Verfahrens weist die Lokalspulenmatrix eine Mehrzahl an zweiten Spulenwicklungen auf. Vorzugsweise bilden dabei die Mehrzahl der zweiten Spulenwicklungen eine Matrix oder ein Gitter aus, das mit den von den zweiten Spulenwicklungen umschlossenen Flächen einen zweidimensionalen Untersuchungsbereich im Wesentlichen abdeckt, d.h. bis auf Lücken, die kleiner als 20%, 10% oder 5 % der umschlossenen Fläche sind. Es sind dabei erste Spulenwicklungen vorgesehen, deren Sensitivitätsbereich Teilmenge des Sensitivitätsbereichs der jeweiligen zweiten Spulenwicklung ist. Dabei können die von den zweiten Lokalspulen umschlossenen Flächen überlappen oder disjunkt sein.

Auf vorteilhafte Weise ermöglicht die Lokalspulenmatrix durch mehrere zweite Lokalspulenwicklungen größere Bereiche des Patienten bei einer Untersuchung zu erfassen.

Im Rahmen des in Anspruch 1 definierten Verfahrens weist die Lokalspulenmatrix eine Steuerung und die ersten Spulenwicklungen Verstimmungselemente in Signalverbindung mit der Steuerung auf. Beispielsweise können PIN-Dioden oder Schaltelemente in Verbindung mit Kapazitäten oder Induktivitäten vorgesehen sein, mit denen eine erste Spulenwicklung durch die Steuerung von einem Zustand mit einer Resonanz bei einer Larmorfrequenz des Magnetresonanztomographen in einen nicht-resonanten Zustand gebracht werden kann. Als nichtresonanter Zustand wird dabei ein Zustand angesehen, bei dem die erste Spulenwicklung bei gleichem einwirkenden B1-Feld mit Larmorfrequenz eine um mehr als 12dB, 24dB, 40dB oder 60dB geringere Amplitude eines induzierten Stroms bzw. Spannung gegenüber einer induzierten Spannung bei gleichem B1-Feld im resonanten Zustand aufweist. Dabei ist es auch denkbar, dass das Verstimmen z.B. mit der PIN-Diode, in mehreren Stufen oder kontinuierlich zwischen den Zuständen erfolgen kann.

Auf vorteilhafte Weise ermöglicht es das Schalten der ersten Spulenwicklungen in resonanten und nicht-resonanten Zustand bzw. eine kontinuierliche Verstimmung, die ersten Spulenwicklungen als Resonanzelemente bei der Anregung der Kernspins zu verwenden, um je nach Phase das B1-Feld gezielt an unterschiedlichen Orten zu verstärken oder abzuschwächen und so ein Bl-Shimming der Feldverteilung des Anregungspulses zur Homogenisierung der Anregung vorzunehmen. Dabei kann die Einstellung für jeden Anregungspuls individuell angepasst und so beispielsweise die SAR-Belastung reduziert werden.

Im Rahmen des in Anspruch 2 definierten Verfahrens weist die Lokalspulenmatrix mehrere Koppelelemente sowie eine Steuerung auf. Als Koppelelemente werden hierbei Schaltelemente angesehen, die aufgrund eines über eine Signalverbindung zwischen Steuerung und Koppelelement angelegten Steuersignals der Steuerung eine oder mehrere elektrische Verbindung herstellen und/oder auch öffnen können. Als elektrische Verbindung über das Koppelelement wird dabei eine Verbindung angesehen, bei der insbesondere ein Hochfrequenzsignal mit Larmorfrequenz eines bildgebenden Magnetresonanztomographen eine Dämpfung von weniger als 3 dB, 6 dB oder 12 dB erfährt.

Die elektrische Verbindung ist im Sinne der Erfindung gelöst, wenn das Hochfrequenzsignal bei Durchgang durch das geöffnete Koppelelement um mehr als 18 dB, 24 dB, 36 dB oder 60 dB gedämpft wird. Koppelelemente können beispielsweise durch Relais, mikromechanische Schalter, PIN-Dioden oder Transistoren realisiert werden. Denkbar sind auch Kombinationen mehrerer Schaltelemente zu einem Koppelelement, beispielsweise, um eine Verbindung schließen und gleichzeitig eine andere Verbindung öffnen zu können, oder um gleichzeitig mehrere Verbindungen bereitzustellen.

Die Koppelelemente stehen jeweils mit mindestens zwei Segmenten einer Spulenwicklung in Signalverbindung und die Steuerung ist ausgelegt, die mindestens zwei Spulensegmente mit Hilfe des Koppelelements bzw. der Koppelelemente zu verbinden bzw. zu trennen. Dabei ist es denkbar, dass erst durch das Aktivieren eines ersten Schaltzustandes eines Koppelements eine Spulenwicklung in dem Sinne gebildet wird, dass eine geschlossene elektrisch Verbindung für ein Hochfrequenzsignal mit Larmorfrequenz zwischen zwei benachbarten Anschlussstellen um eine umschlossene Fläche gebildet wird, sodass durch ein magnetisches Wechselfeld mit Larmorfrequenz durch die Fläche ein Magnetresonanzsignal an den Anschlussstellen induziert wird bzw. umgekehrt durch Zuführen eines Sendesignals an den Anschlussstellen ein magnetisches Wechselfeld durch die umschlossene Fläche erzeugt wird. Vorzugsweise weist eine derartig gebildete Spulenwicklung nur eine Windung auf, da dann das Koppelelement nur eine Verbindung zwischen den Spulensegmenten herstellen muss. Es sind aber auch mehrere Windungen mit komplexeren Koppelelementen denkbar. Das Aktivieren eines zweiten Schaltzustandes durch die Steuerung kann beispielsweise eine elektrische Verbindung wieder gelöst bzw. geöffnet werden. Dabei können der erste und zweite Schaltzustand je nach Verschaltung der Koppelelemente und der Spulensegmente beispielsweise der geöffnete oder der geschlossene Zustand sein oder auch ein Wechsel zwischen zwei elektrischen Verbindungen.

Auf vorteilhafte Weise erlaubt es die Lokalspulenmatrix durch die Koppelelemente, variabel unterschiedliche Spulenwicklungen aus den Spulensegmenten zu schalten und so die Sensitivitätsbereiche zur Optimierung der Bilderfassung flexibel anzupassen. Erfindungsgemäß können durch die Koppelelemente flexibel unterschiedliche Muster an ersten und zweiten Spulenwicklungen bereitgestellt werden, sodass dieses mit den nachfolgend beschriebenen Verfahren mit Unterabtastung bzw. "Compressed Sensing" effizienter abgetastet werden kann. Gleichzeitig ist es denkbar, dass beim Anregungspuls, wie schon beschrieben, die durch die Koppelemente und Spulensegmente durch Verschaltung gebildeten Spulenwicklungen als resonante Elemente ein Bl-Shimming ermöglichen. Es ist auch möglich, die konfigurierbaren Spulenwicklungen als Sendeantennen zu nutzen, sodass bei einer Unterabtastung nur jeweils die Kernspins in den zu erfassenden Unterbereichen und nicht in dem ganzen abzubildenden Bereich angeregt werden, wodurch die globale SAR-Belastung im ganzen Körper reduziert wird.

In einer möglichen Ausführungsform der Lokalspulenmatrix ist das Spulensegment selbstresonant bei der Larmorfrequenz ausgebildet. Darunter ist zu verstehen, dass das Spulensegment allein, d.h. ohne Verschaltung mit anderen Spulensegmenten bereits bei der Larmorfrequenz eine Resonanz aufweist. Dies kann beispielsweise erreicht werden, indem das bzw. jedes Spulensegment ein oder mehrere Bauelemente mit komplexem Widerstand aufweist, der in Zusammenwirken mit dem Spulensegment eine Resonanz erzeugt. Dieses kann je nach Verschaltung beispielsweise eine Kapazität und/oder eine Induktivität sein. Denkbar sind auch Wellenleiter mit offenem oder kurzgeschlossenen Enden und einer angepassten Länge, beispielsweise Microstripleitungen oder Koaxialkabelabschnitte.

Denkbar wäre es aber auch, dass das bzw. die Bauelemente Teil des Koppelelements sind und beim Zusammenschalten mit dem Spulensegment jeweils ein selbstresonantes Element bei der Larmorfrequenz des Magnetresonanztomographen bilden.

Auf vorteilhafte Weise ermöglichen es die selbstresonanten Spulensegmente, dass auch beliebige Zusammenschaltungen der Spulensegmente mittels der Koppelelemente zu Spulenwicklungen mit unterschiedlicher Geometrie jeweils wiederum bei der Larmorfrequenz resonant sind.

In einer möglichen Ausführungsform der Lokalspulenmatrix weist die Lokalspulenmatrix eine Vielzahl an Spulensegmenten auf. Dabei spannen die Spulensegmente ein zweidimensionales Netz aus Polygonen auf. Es ist beispielsweise denkbar, dass die Spulensegmente jeweils die Seiten eines Dreiecks, Vierecks oder Hexagons bilden, die zu einem geschlossenen Netzwerk mechanisch verbunden sind, das eine zweidimensionale Fläche bildet. Dabei sind auch jeweils Gebilde gleicher Topologie als Dreiecke, Vierecke oder Hexagon im Sinne der Erfindung anzusehen, bei denen die Verbindungen zwischen den Ecken bzw. Knoten nicht gerade, sondern gekrümmt verlaufen. Denkbar sind auch Netzwerke aus Polygonen mit unterschiedlichen Seitenzahlen. Vorzugsweise handelt es sich um ein Netz aus Hexagonen, denn in den Knotenpunkten treffen jeweils nur drei Spulensegmente zusammen, sodass die Zahl der Schalter in dem Koppelelement reduziert ist.

Denkbar ist es auch, dass dabei nicht jeder Knotenpunkt mit Koppelelementen besetzt ist, sondern dass in einzelnen Knotenpunkten feste Verbindungen vorgesehen sind. Als Knotenpunkt im Sinne der Erfindung werden die Punkte des Netzwerkes aus Polygonen bezeichnet, an denen sich mehr als zwei Spulensegmente treffen. Dabei ist es denkbar, dass die Spulensegmente an diesen Knoten einfach miteinander auf nicht durch Konfiguration veränderbare Weise elektrisch verbunden sind, beispielsweise ohmsch, durch eine Kapazität oder Induktivität. Bei einer Vielzahl an Knoten ist dabei jedoch ein Koppelelement vorgesehen, dass je nach Schaltzustand eine andere elektrische Verbindung zwischen den Spulensegmenten an diesem Knotenpunkt herstellt. Als Vielzahl kann mehr als 10%, 30%, 50% oder 80% der Knoten in dem Netzwerk angesehen werden. Das Koppelelement ist dabei ausgelegt, mindestens zwei der an dem Knoten angrenzenden Spulensegmente lösbar elektrisch zu verbinden.

Auf vorteilhafte Weise können aus Spulensegmenten zweidimensionale flächige Gebilde zusammengestellt werden, die eine Oberfläche, beispielsweise über einem Patienten vollständig abdecken. Die Vielzahl der Koppelelemente erlaubt es, aus dem Netzwerk der Spulensegmente durch Konfiguration unterschiedliche Spulenwicklungen zu bilden und so die Lokalspulenmatrix an unterschiedliche Untersuchungen flexibel bezüglich der Spulengröße und Form anzupassen.

In einer möglichen Ausführungsform der Lokalspulenmatrix weist die Lokalspulenmatrix eine Kombinationsmatrix mit ersten Signalanschlüssen und zweiten Signalanschlüssen sowie eine Steuerung auf. Die Steuerung steht in Signalverbindung mit der Kombinationsmatrix, sodass die Steuerung der Kombinationsmatrix Einstellbefehle zur einstellbaren Konfiguration der Kombinationsmatrix übermitteln kann. Die ersten der Signalanschlüsse stehen mit der Mehrzahl der Spulenwicklungen in Signalverbindung, sodass ein von der Spulenwicklung empfangenes Magnetresonanzsignal zu der Kombinationsmatrix weitergeleitet wird. Die Kombinationsmatrix ist ausgelegt, ein Ausgangssignal in einer von der Steuerung durch Konfigurationsbefehle einstellbaren Abhängigkeit von einer Mehrzahl an ersten Signalanschlüssen anliegenden Eingangssignalen an einem zweiten Signalanschluss auszugeben. Denkbar ist es beispielsweise, dass die Signale an den ersten Signalanschlüssen zu einem Summensignal addiert werden und das Ergebnis an dem zweiten Signalanschluss ausgegeben wird. Dabei können die Signale auch zuerst einer Gewichtung und/oder Phasenverschiebung unterworfen werden. Grundsätzlich sind auch andere lineare oder nichtlineare Funktionen und Relationen der Signale von den ersten Signalanschlüssen zur Bildung des Signals an dem zweiten Signalanschluss denkbar.

Die Kombinationsmatrix ermöglicht es auf vorteilhafte Weise, bei einer Unterabtastung bzw. Compressed Sensing die erfassten Signale in unterschiedlichen einstellbaren Weise zusammenzufassen, sodass die unterschiedlichen unterabgetasteten Signale bereits in der Lokalspule erzeugt werden und weniger Verbindungsleitungen zum Empfänger in dem Magnetresonanztomographen erforderlich sind.

In einer möglichen Ausführungsform des erfindungsgemäßen Verfahrens zur Bilderfassung mit einem Magnetresonanztomographen mit einer Lokalspulenmatrix weist die Lokalspulenmatrix eine Steuerung in Signalverbindung mit Verstimmungselementen oder Spulensegmente und Koppelelemente in Signalverbindung mit der Steuerung auf.

In einem Schritt des Verfahrens sendet der Magnetresonanztomograph einen ersten Anregungspuls aus. Der Anregungspuls ist dabei ausgelegt, Kernspins in einem Untersuchungsobjekt in dem Magnetresonanztomographen anzuregen. Der Anregungspuls kann beispielsweise über eine Körperspule oder auch über eine Lokalspule, beispielsweise mit den ersten und/oder zweiten Spulenwicklungen der Lokalspulenmatrix ausgesendet werden. Dabei ist die Auswahl der zweiten Spulenwicklungen zum Senden derart, dass zumindest in einem Sensitivitätsbereich, der nachfolgend als zweite Menge der ersten Spulenwicklungen bezeichnet wird, die Kernspins angeregt werden.

In einem anderen Schritt des Verfahrens werden die angeregten Spins mittels der Gradientenspulen phasenkodiert, um den Kernspins eine räumliche Position aufzuprägen.

In einem weiteren Schritt werden Magnetresonanzsignale mittels einer zweiten Menge an ersten Spulenwicklungen und/oder zweiten Spulenwicklungen empfangen, d.h. einzeln oder kombiniert einem Empfänger des Magnetresonanztomographen zu weiteren Verarbeitung und einer Bilderfassung zugeführt.

In einem weiteren Schritt gibt der Magnetresonanztomograph einen zweiten Anregungspuls aus. Dies kann genauso wie beim Aussenden des ersten Anregungspulses erfolgen. Es ist dabei aber auch denkbar, dass das Senden mit einer anderen räumlichen Verteilung durch Auswahl anderer erster und/oder zweiter Spulenwicklungen der Lokalspulenmatrix als beim ersten Senden erfolgt, sodass zumindest in einem Sensitivitätsbereich, der nachfolgend als vierte Menge der ersten bzw. zweiten Spulenwicklungen bezeichnet wird, die Kernspins angeregt werden. So kann die mittlere SAR-Belastung gesenkt werden.

In einem weiteren Schritt des Verfahrens werden die angeregten Spins mittels der Gradientenspulen phasenkodiert, um den Kernspins eine räumliche Position aufzuprägen.

In einem anderen Schritt des erfindungsgemäßen Verfahrens werden Magnetresonanzsignale mittels einer vierten Menge an ersten Spulenwicklungen und/oder zweiten Spulenwicklungen empfangen, d.h. einzeln oder kombiniert einem Empfänger des Magnetresonanztomographen zu weiteren Verarbeitung und einer Bilderfassung zugeführt. Dabei ist die zweite Menge ungleich der vierten Menge, sodass die empfangenen Signale eine andere räumliche Sensitivität aufweisen, mit anderen Worten aus einem Volumen des Patienten stammen, das sich zumindest in Teilbereichen von einem Volumen bei dem vorgehenden Empfangen mit der zweiten Menge unterscheidet.

Auf vorteilhafte Weise erlaubt das erfindungsgemäße Verfahren eine Unterabtastung des Untersuchungsbereichs, die eine räumliche "diversity" aufweist d.h. den Untersuchungsbereich mit unterschiedlich Empfindlichkeitsbereichen abtastet, die vorzugsweise auch eine unterschiedlicher räumlicher Ausdehnung besitzen. Vorzugsweise erfasst bzw. bedeckt die Vereinigungsmenge der Empfindlichkeitsbereiche der zur Erfassung eingesetzten Menge an Spulenwicklungen die gesamte zur Lokalspulenmatrix benachbarte Oberfläche des Untersuchungsbereichs.

Erfindungsgemäß werden die Schritte des Sendens, Codierens und Empfangens mit jeweils unterschiedlichen zweiten Mengen und vierten Mengen wiederholt und in Abhängigkeit von den von der Mehrzahl der zweiten Mengen und der vierten Mengen empfangenen Magnetresonanzsignalen eine Abbildung der Untersuchungsbereichs mit dem Magnetresonanztomographen erzeugt.

Erfindungsgemäß erfolgt die Bilderzeugung mit Hilfe des als "Compressed Sensing" bezeichneten Verfahrens.

Auf vorteilhafte Weise kann mit den erfassten Daten, die den Untersuchungsbereich mit unterschiedlichen räumlichen Sensitivitätsbereichen unterabtasten, durch das als "Compressed Sensing" bekannte Verfahren zur Bildrekonstruktion in kürzerer Messzeit eine Abbildung mit besserer Qualität bereitgestellt werden.

In einer möglichen Ausführungsform des erfindungsgemäßen Verfahrens weist die Lokalspulenmatrix eine Kombinationsmatrix auf, die in Signalverbindung mit der Steuerung steht. Die Kombinationsmatrix stellt, angesteuert von der Steuerung, in den Schritten des Empfangens in Abhängigkeit von den Magnetresonanzsignalen der zweiten Mengen bzw. der vierten Mengen der ersten Spulenwicklungen und/oder zweiten Spulenwicklungen, die zum Empfang ausgewählt sind, jeweils Ausgangssignale bereit, deren Anzahl kleiner ist als die Anzahl der Spulenwicklungen in den zweiten Mengen bzw. vierten Mengen.

Mit anderen Worten wird die Anzahl der Signale durch Kombination reduziert. Wenn beispielsweise die Anzahl der Spulenwicklungen in der zweiten bzw. vierten Menge als m bezeichnet wird, so erzeugt die Kombinationsmatrix eine Anzahl von n Ausgangssignalen, wobei m > n. Bei Compressed Sensing ist es dabei auch denkbar, dass n = 1 ist.

Dies kann beispielsweise durch Abbildungsfunktionen von m Eingangsvariablen auf n Ausgangsvariablen erfolgen wie Linearkombination oder andere mathematisch Abbildungen.

Da Compressed Sensing auf einer Unterabtastung beruht, kann die Anzahl der Eingangskanäle reduziert werden. Vorteilhafter Weise erfolgt dies bereits in der Lokalspulenmatrix durch die Kombinationsmatrix, sodass die Anzahl der Verbindungsleitungen und Empfangskanälen in dem Magnetresonanztomographen reduziert werden kann.

In einer denkbaren Ausführungsform des Verfahrens wiederholen sich bei wiederholten Schritten des Empfangens zweite Mengen und vierte Mengen mit jeweils gleichen Sensitivitätsbereichen zufällig ohne Periodizität. Es kann beispielsweise sein, dass eine Bilderfassung mehr Wiederholungen an Anregung, Codierung und Auslesen bzw. Empfangen der Kernresonanzsignale erfordert, als die Anzahl der Kombinationen von ersten Spulenwicklungen und zweiten Spulenwicklungen zu zweiten Mengen und vierten Mengen. Eine Wiederholung des Auslesens/Empfangens mit gleicher zweiter Menge bzw. vierter Menge mit gleicher Sensitivitätsverteilung bzw. Muster ist dann unumgänglich. Vorzugsweise erfolgt dann die Wiederholung gleicher Muster nicht regelmäßig bzw. periodisch, sondern nach einem zeitlich zufälligen Wiederholungsmuster.

Auf vorteilhafte Weise führt eine zufällige Wiederholung der Sensitivitätsmuster beim Erzeugen einer Abbildung aus den Kernresonanzsignalen mittels Compressed Sensing zu einem besseren Ergebnis.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine beispielhafte schematische Darstellung eines Magnetresonanztomographen mit einer Hochfrequenzansteuerung zur Ausführung des erfindungsgemäßen Verfahrens;
- Fig. 2: eine schematische Darstellung von Spulenwicklungen einer ersten Ausführungsform einer Lokalspulenmatrix zur Ausführung des erfindungsgemäßen Verfahrens;
- Fig. 3: eine schematische Darstellung einer anderen Ausführungsform einer Lokalspulenmatrix zur Ausführung des erfindungsgemäßen Verfahrens;
- Fig. 4: eine schematische Darstellung für Konfigurationsbeispiele der anderen Ausführungsform einer Lokalspulenmatrix zur Ausführung des erfindungsgemäßen Verfahrens;
- Fig. 5: eine schematische Darstellung einer anderen Ausführungsform einer Lokalspulenmatrix zur Ausführung des erfindungsgemäßen Verfahrens;
- Fig. 6: eine schematische Darstellung einer anderen Ausführungsform einer Lokalspulenmatrix zur Ausführung des erfindungsgemäßen Verfahrens;
- Fig. 7: eine schematische Darstellung eines Koppelements einer Lokalspulenmatrix zur Ausführung des erfindungsgemäßen Verfahrens;
- Fig. 8: eine schematische Darstellung von Schaltkonfigurationen des Koppelelements;
- Fig. 9: eine schematische Darstellung eines Koppelements einer Lokalspulenmatrix zur Ausführung des erfindungsgemäßen Verfahrens;
- Fig. 10: eine schematische Darstellung von Schaltkonfigurationen des Koppelelements;
- Fig. 11: eine schematische Darstellung von Sensitivitätsbereichen unterschiedlicher Konfigurationen der Lokalspulenmatrix an einem Patienten;
- Fig. 12: eine zeitliche Abfolge einer beispielhaften Magnetresonanzmessung des erfindungsgemäßen Verfahrens;
- Fig. 13: einen schematischen Ablaufplan eines Verfahrens, das nur einen Teil der Schritte eines erfindungsgemäßen Verfahrens enthält und daher als solches nicht in den Schutzumfang der Erfindung fällt;
- Fig. 14: einen schematischen Ablaufplan eines erfindungsgemäßen Verfahrens.

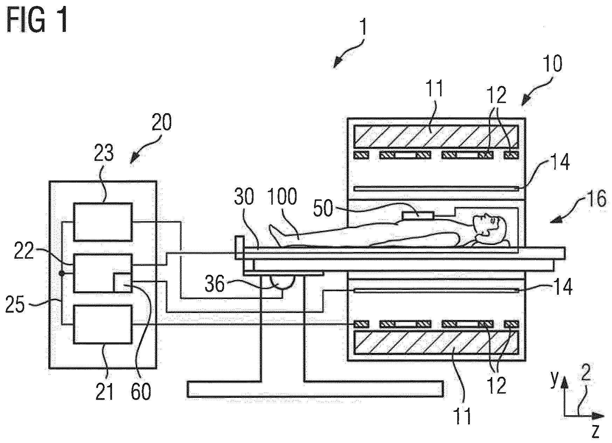

Fig. 1 zeigt eine schematische Darstellung einer Ausführungsform eines Magnetresonanztomographen 1 mit einer Lokalspulenmatrix 50 zur Ausführung des erfindungsgemäßen Verfahrens.

Die Magneteinheit 10 weist einen Feldmagneten 11 auf, der ein statisches Magnetfeld B0 zur Ausrichtung von Kernspins von Proben bzw. Patienten 100 in einem Aufnahmebereich erzeugt. Der Aufnahmebereich ist in einem Patiententunnel 16 angeordnet, der sich in einer Längsrichtung 2 durch die Magneteinheit 10 erstreckt. Ein Patient 100 ist mittels der Patientenliege 30 und der Verfahreinheit 36 der Patientenliege 30 in den Aufnahmebereich verfahrbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung 33 zugeführtes Hochfrequenzsignal in das Untersuchungsvolumen abzustrahlen und von dem Patient 100 emittierte Resonanzsignale zu empfangen und über eine Signalleitung abzugeben. Bevorzugter Weise wird aber die Körperspule 14 für das Aussenden des Hochfrequenzsignals und/oder das Empfangen durch Lokalspulenmatrix 50 ersetzt, die in dem Patiententunnel 16 nahe am Patient 100 angeordnet sind. Es ist aber auch denkbar, dass die Lokalspulenmatrix 50 zum Senden und Empfangen ausgelegt ist und deshalb eine Körperspule 14 entfallen kann.

Eine Steuereinheit 20 versorgt die Magneteinheit 10 mit den verschiedenen Signalen für die Gradientenspulen 12 und die Körperspule 14 und wertet die empfangenen Signale aus. Eine Magnetresonanztomographen-Steuerung 23 koordiniert dabei die Untereinheiten.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die einzelnen Einheiten sind über einen Signalbus 25 untereinander verbunden.

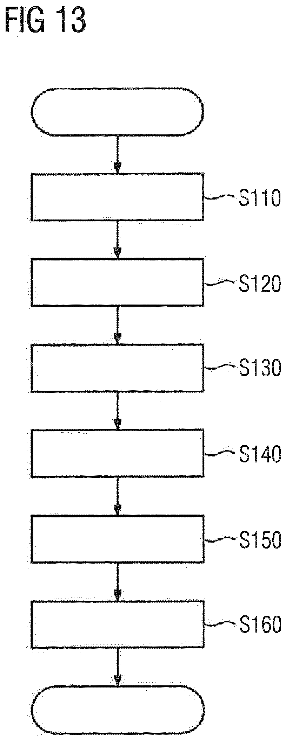

Das von Hochfrequenzeinheit 22 erzeugte Hochfrequenzsignal wird über eine Signalverbindung der Körperspule 14 zugeführt und in den Körper des Patienten 100 ausgesendet, um dort die Kernspins anzuregen. Dabei können die Spulenwicklungen der Lokalspulenmatrix 50 wie nachfolgend zu Fig. 13 erläutert, ein zeitlich variables Bl-Shimming durch resonante Abstimmung vornehmen. Denkbar ist aber auch ein Aussenden des Hochfrequenzsignals über eine oder mehrere Spulenwicklungen der Lokalspulenmatrix 50.

Die Lokalspulenmatrix 50 empfängt dann vorzugsweise ein Magnetresonanzsignal aus dem Körper des Patienten 100, denn aufgrund des geringen Abstandes ist das Signal-zu-Rauschverhältnis (SNR) der Lokalspulenmatrix 50 besser als bei einem Empfang durch die Körperspule 14. Das von der Lokalspulenmatrix 50 empfangene MR-Signal wird in der Lokalspulenmatrix 50 aufbereitet und an die Hochfrequenzeinheit 22 des Magnetresonanztomographen 1 zur Auswertung und Bilderfassung weitergeleitet. Vorzugsweise wird dazu die Signalverbindung 33 genutzt, es ist aber beispielsweise auch eine drahtlose Übertragung denkbar.

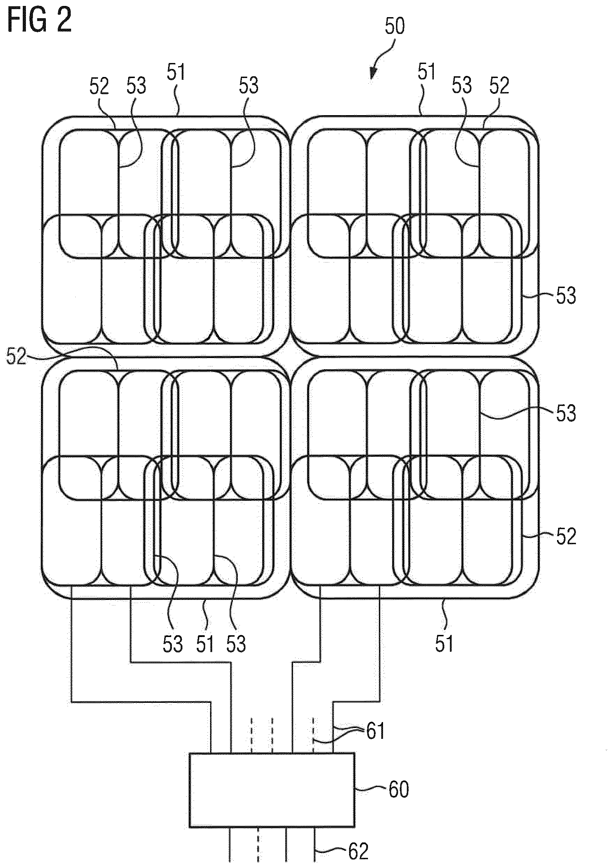

In Fig. 2 ist eine beispielhafte Ausführungsform der Lokalspulenmatrix 50 zur Ausführung des erfindungsgemäßen Verfahrens mit Spulenwicklungen 51, 52, 53 schematisch dargestellt. Die Spulenwicklungen 51, 52 und 53 unterscheiden sich in der Größe der von ihnen umschlossenen Fläche. Die größten Spulenwicklungen 51 umschließen jeweils eine Fläche, die wiederum durch die Vereinigungsmenge der von den mittleren Spulenwicklungen 52 umschlossenen Flächen ebenfalls abgedeckt wird. Mit anderen Worten, eine große Spulenwicklung 51 bedeckt mit der umschlossenen Fläche die gleiche Fläche wie die umschlossenen Flächen einer Mehrzahl mittlerer Spulenwicklungen 52 (im Beispiel 2). Bedecken kann zunächst im bildlichen Sinne verstanden werden, wesentlich im Sinne der Erfindung ist jedoch, dass die Spulen aufgrund der geometrischen Bedeckung eine Sensitivität für Magnetresonanzsignale innerhalb dieser Fläche bzw. Flächen in einem räumlichen Bereich entlang einer Flächennormale zu diesen Flächen aufweisen. Dabei bewirkt die Überdeckung der Flächen, dass ein Magnetresonanzsignal einer Quelle unter der größten Spulenwicklung 51 immer auch von zumindest einer der mittleren Spulen 52 erfasst werden kann, soweit es nicht entlang der Flächennormale zu weit von den umschlossenen Flächen entfernt ist, um von der mittleren Spulenwicklung 52 noch erfasst zu werden. Als Erfassen kann dabei angesehen werden, dass ein Magnetresonanzsignal, das in einer mittleren Annenspule 52 eine Spannung induziert, eine um höchstens 3dB, 6dB oder 12 dB höhere Spannung in der größten Spulenwicklung 51 erzeugt.

Das gleiche gilt auch für die Beziehung der kleinsten Spulenwicklungen 53 zu den mittleren Spulenwicklungen 52 und den größten Spulenwicklungen 51. In der beispielhaften Ausführungsform bedecken jeweils 4 kleinste Spulenwicklungen 53 die gleiche Fläche wie eine mittlere Spulenwicklung 52 und 8 kleinste Spulenwicklungen 53 die Fläche einer größten Spulenwicklung 51. Zumindest für Untersuchungsbereiche nahe der Lokalspulenmatrix 50, d.h. mit einem Abstand von der Lokalspulenmatrix 50, der kleiner als die Tiefe des Sensitivitätsbereichs der kleinsten Spulenwicklung 53 ist, kann ein Magnetresonanzsignal wahlweise mit einer größten Spulenwicklung 51, einer mittleren Spulenwicklung 52 oder einer kleinsten Spulenwicklung 53 erfasst werden. Vorzugsweise wird dabei jeweils die Spulenwicklung mit dem kleinstmöglichen Sensitivitätsbereich, d.h. auch umschlossenen Fläche, zum Empfang genutzt, mit der (wegen der Tiefe) das Magnetresonanzsignal noch erfasst werden kann, denn dadurch verbessert sich das Signal-zu-Rausch-Verhältnis. Es sind aber auch andere Anwendungen denkbar, bei denen z.B. ein großes Volumen nur schnell abgetastet werden soll oder bei denen unterschiedliche räumliche Sensitivitätsbereiche wünschenswert sind.

In der Fig. 2 überlappen auch jeweils benachbarte mittlere Spulenwicklungen 52 und benachbarte kleinste Spulenwicklungen 53 in den Randbereichen miteinander, um benachbarte Spulenwicklungen zu entkoppeln. Es wäre aber auch denkbar, die Spulenwicklungen gleicher Größe jeweils disjunkt anzuordnen und die Entkopplung mit anderen Maßnahmen, z.B. durch Entkopplungskondensatoren, zu erreichen.

Denkbar ist es dabei auch, dass eine Lokalspulenmatrix nur zwei Ebenen an Spulenwicklungen unterschiedlicher Größe Aufweist, beispielsweise nur größte Spulenwicklungen 51 und kleinste Spulenwicklungen 53, oder noch mehrere unterschiedliche Größenklassen, wobei zumindest jeweils 2 Größenklassen wie z.B. zu den größten Spulenwicklungen 51 und den mittleren Spulenwicklungen 52 zuvor dargelegt, einander überdecken.

In Fig. 2 ist auch eine Schaltmatrix 60 der Lokalspulenmatrix 50 dargestellt, die in Signalverbindung mit jeder der größten Spulenwicklungen 51, der mittleren Spulenwicklungen 52 und der kleinsten Spulenwicklungen 53 an m ersten Signalanschlüssen 61 steht, Der Übersichtlichkeit halber sind nicht alle Signalverbindungen in der Fig. 2 dargestellt. An n zweiten Signalanschlüssen 62 besteht eine Signalverbindung, beispielsweise über Kabel oder drahtlos, zu dem Magnetresonanztomographen 1. Die Schaltmatrix 60 ist dabei ausgelegt, von jedem der m ersten Signalanschlüsse 61 zumindest mit einem zweiten Signalanschluss 62 eine Signalverbindung schalten zu können. Vorzugsweise ist dabei m > n, sodass die Anzahl der Signalverbindungen zum Magnetresonanztomographen 1 geringer ist und nur die Signale der aktuell zur Erfassung benötigten Spulenwicklungen weitergeleitet werden. Als Schalter in der Schaltmatrix können beispielsweise Relais, Transistoren, PIN-Dioden oder MEMS-Schalter verwendet werden. Denkbar ist es dabei auch, dass die Schaltmatrix 60 nicht nur Empfangssignale von den Spulenwicklungen zu Empfängern des Magnetresonanztomographen leitet, sondern umgekehrt auch Sendesignale zur Anregung der Kernspins von einem Sender des Magnetresonanztomographen 1 zu den Spulenwicklungen.

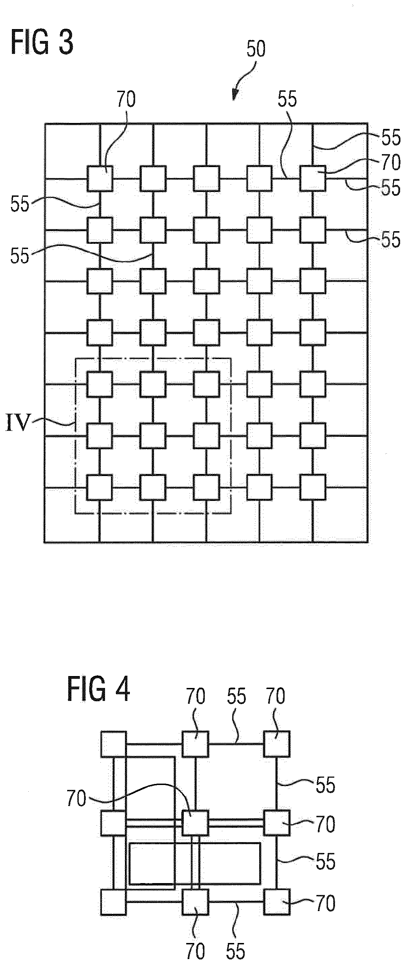

Fig. 3 zeigt eine schematische Darstellung einer anderen Ausführungsform einer Lokalspulenmatrix 50 zur Ausführung des erfindungsgemäßen Verfahrens. Diese Ausführungsform weist eine Vielzahl an Spulensegmenten 55 auf, die in einem Gitter angeordnet sind. Als Spulensegmente 55 werden dabei elektrische Leiter angesehen, die eine Längserstreckung aufweisen und die durch Verbinden mittels elektrischer Verbindungen zu einer Spulenwicklung für Hochfrequenzsignale mit einer Larmorfrequenz des Magnetresonanztomographen 1 zusammenfügbar sind. Dies können beispielsweise Abschnitte gut leitender Drähte oder Hochfrequenzlitzen, aber auch Leiterbahnen auf flexiblen oder starren Trägermaterialien für Hochfrequenzschaltungen sein. Vorzugsweise weisen die Trägermaterialien dabei geringe dielektrische Verluste auf. Die Leiter können dabei in geeignete Isoliermaterialien eingebettet sein. Denkbar sind als Leiter auch exotische Materialien wie Supraleiter, Hochtemperatursupraleiter, Kohlenstoffnanoröhrchen oder Graphen.

Die Spulensegmente 55 sind derart durch Koppelelemente 70 miteinander verbunden, dass über mehrere Spulensegmente 55 durch mehrere Koppelelemente 70 eine elektrisch durchgehende Leiterschleife herstellbar ist, die zum Erzeugen oder Empfangen eines Magnetresonanzsignals geeignet ist. Die Koppelelemente 70 können dazu, wie nachfolgend dargelegt, verschiedene Arten von steuerbaren Schaltelementen aufweisen, die von einer Steuerung 80 über Signalverbindungen angesteuert werden.

In Fig. 4 ist eine schematische Darstellung für Konfigurationsbeispiele der Lokalspulenmatrix 50 angegeben, wie sie mit unterschiedlichen Einstellungen der Koppelelemente 60 erzielt werden können. Durch geeignetes Verbinden der einzelnen Spulensegmente 55 durch die Koppelelemente 60 kann zum Beispiel eine im Inneren angedeutete, aufrecht stehende Form einer Spulenwicklung geschaltet werden, die die Außenumgrenzung eines aus den zwei linken Quadraten gebildeten Rechtecks umfasst. Ebenso kann beispielsweise eine Spulenwicklung in Form des liegenden Rechtecks geschaltet werden.

Ebenfalls nicht in Fig. 3 und 4 dargestellt sind Signalverbindungen, über die die Spulenwicklung Empfangssignale weiter zum Magnetresonanzempfänger leitet oder zum Aussenden von diesem erhält. Diese Signalverbindungen können entweder direkt an eine Mehrzahl der Spulensegmente 55 angeschlossen sein. Es ist aber auch denkbar, dass die Signalverbindungen an einer Mehrzahl an Koppelelementen 70 vorgesehen sind, sodass diese Verbindungen schaltbar sind. Damit können die Koppelelemente 70 gleichzeitig eine Funktion vergleichbar der Schaltmatrix 60 übernehmen, indem sie aus einer Mehrzahl von anliegenden Spulensegmenten eines zum Verbinden auswählen und so eine Leiterschleife, in die das Spulensegment 55 und das Koppelelement 70 durch Konfiguration eingebunden sind, steuerbar mit dem Magnetresonanztomographen verbinden. Auf diese Weise kann allein durch die Koppelelemente die Anzahl der Signalverbindungen zwischen Lokalspulenmatrix 50 und Magnetresonanztomograph 1 kleiner als die Zahl der konfigurierbaren Spulenwicklungen aus Koppelelementen 70 und Spulensegmenten 55 gehalten werden. Beispiele hierzu sind nachfolgend näher erläutert.

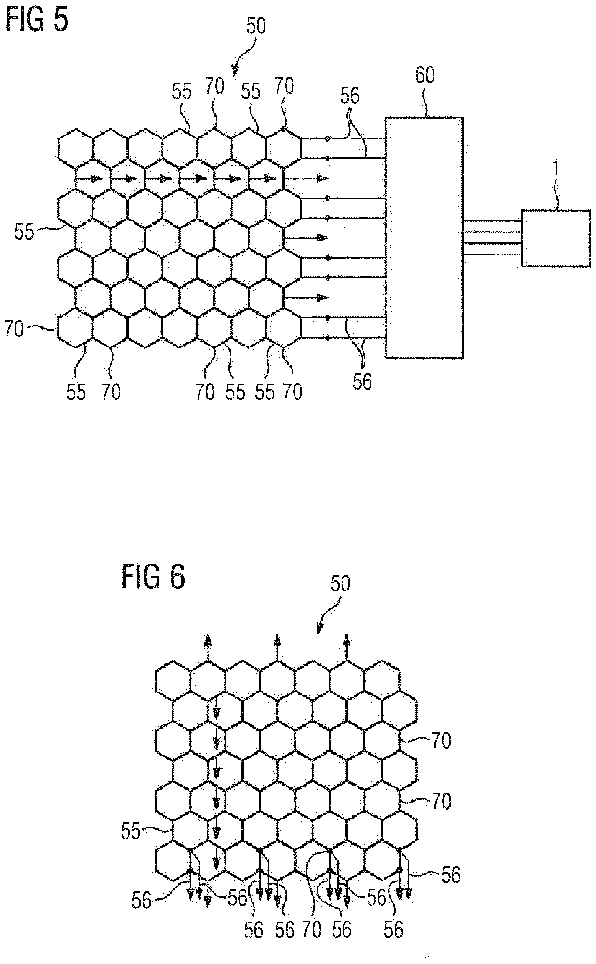

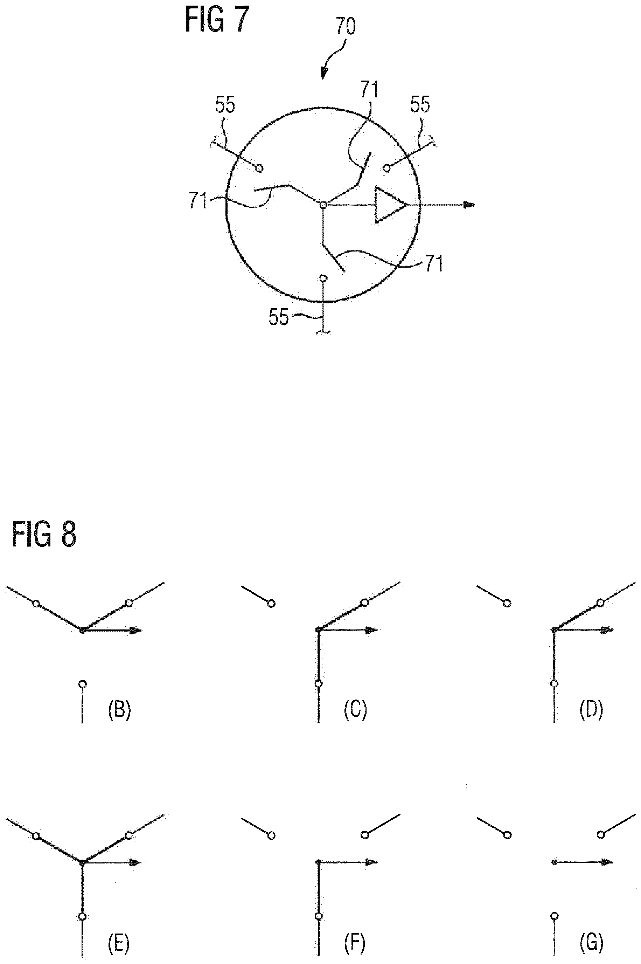

In Fig. 5 ist eine weitere Ausführungsform einer Lokalspulenmatrix zur Ausführung des erfindungsgemäßen Verfahrens dargestellt. Die Lokalspulenmatrix 50 in Fig. 5 unterscheidet sich von der Ausführungsform der Fig. 4 darin, dass die Spulensegmente 55 und Koppelelemente 70 nicht ein Gitter mit quadratischen Grundelementen bilden, sondern ein hexagonales Gitter. Der wesentliche Vorteil des hexagonalen Gitters ist es, dass an jedem Knoten, nur jeweils drei Spulensegmente 55 zusammentreffen. Ein an einem Knoten angeordnetes Koppelelement 70 benötigt daher maximal drei Schaltelemente, wie nachfolgend in Fig. 7 dargestellt ist, um flexibel alle Spulensegmente 55 miteinander verbinden zu können. In Fig. 5 ist weiterhin eine Schaltmatrix 60 dargestellt, die mit jeweils zwei benachbarten Koppelelementen 70 in Signalverbindung 56 steht.

Mit den dargestellten Signalverbindungen 56 zu den Koppelementen 70 wäre es beispielsweise möglich, die Spulensegmente zu länglichen Spulenwicklungen zu verschalten und dann über die Schaltmatrix 60 zu verbinden, sodass zeilenweise über den Untersuchungsbereich Spulenwicklungen angeordnet sind und beispielsweise eine schichtweise Abtastung möglich wäre.

In Fig. 6 ist eine entsprechende Lokalspulenmatrix 50 mit Signalverbindungen 56 dargestellt, die eine Abtastung mit länglichen, vertikal angeordneten Spulenwicklungen erlauben würde.

Denkbar sind auch Mischformen mit vertikaler und horizontaler Anbindung an den Rändern der Lokalspulenmatrix 55. Eine besonders flexible Konfiguration erlaubt eine aus Gründen der Übersichtlichkeit nicht dargestellte Ausführungsform, bei der die Signalverbindungen 56 zwischen Schaltmatrix 60 und Koppelelementen 70 flächig über die Lokalspulenmatrix verteilt sind. Dabei sind vorzugsweise nicht alle, sondern nur ein Teil, beispielsweise 50%, 30%, 10% oder weniger der Koppelelemente 70 oder Spulensegmente 55 mit einer Signalverbindung 56 zu der Schaltmatrix 60 versehen. Die Verteilung kann gleichmäßig oder nach einem willkürlichen Muster erfolgen. Eine derartige Verteilung ermöglicht es, über die Fläche mit unterschiedlich großen Spulenwicklungen eine Magnetresonanzmessung vorzunehmen.

In Fig. 7 ist ein beispielhaftes Koppelelement 70 einer Lokalspulenmatrix 50 zur Ausführung des erfindungsgemäßen Verfahrens dargestellt. Das Koppelelement 70 ist mit drei Spulensegmenten 55 verbunden, zwischen denen es mittels Schaltelementen 71 eine Verbindung herstellen kann. Denkbar sind aber auch andere geometrische Konfigurationen der Koppelmatrix, bei denen mehr als drei Spulensegmente 55 an einem Koppelelement zusammentreffen, sodass das Koppelelement 70 entsprechend Schaltelemente 71 aufweist.

Nicht dargestellt in Fig. 7 ist eine Steuerleitung, mittels derer das Koppelelement 70 bzw. die Schaltelemente 71 gesteuert werden. Denkbar ist es, dass die Schalter direkt durch separate Ansteuerleitungen mittels einer Spannung und/oder eines Stromes angesteuert werden, wie es beispielsweise bei PIN-Dioden oder Transistoren möglich ist. Wegen der dafür erforderlichen vielen Steuerleitungen, die das magnetische Wechselfeld stören, werden aber vorzugsweise intelligente Schaltelemente 71 verwendet, die es erlauben, über eine oder wenige Leitungen mehrere Koppelelemente bzw. Schaltelemente zu steuern. Denkbar wäre es beispielsweise, eine Busleitung zu verwenden, die eine Mehrzahl oder alle Koppelelemente 70 mit einer Steuerung des Magnetresonanztomographen verbindet und so eine Konfiguration der Lokalspulenmatrix 50 bei einer Magnetresonanztomographie ermöglicht. Die Busleitung könnte dabei die Energieversorgung und die Ansteuerung übernehmen, indem einer Gleich- oder Wechselspannung ein Steuersignal mit Adressen und Steuerbefehlen aufmoduliert wird. Es wäre auch denkbar, durch Trennung der Frequenzen die Signalverbindung 56 für die Magnetresonanzsignale auch für die Energieversorgung und ein Steuersignal zu verwenden. Insbesondere bei einer Digitalisierung des Magnetresonanzsignals bereits durch einen AD-Wandler in dem Koppelelement 70 ist eine gemeinsame Nutzung der Signalverbindung 56 auch für Steuersignale denkbar.

In der Ausführungsform der Fig. 7 stehen die Schaltelemente 71 an einem gemeinsamen Punkt sternförmig in Signalverbindung, von dem aus auch die Signalverbindung 56 zu der Schaltmatrix 60 und/oder dem Magnetresonanztomographen 1 besteht.

Die Fig. 8 gibt mögliche Schaltkonfigurationen des in Fig. 7 dargestellten Koppelelements 70 an. Die Variationen reichen von einer Öffnung aller Schaltelemente 71 in G, bei der alle anliegenden Spulensegmente 55 voneinander getrennt sind, über die Verbindung eines einzelnen Spulensegments 55 mit der Signalverbindung 56 in F oder einer Verbindung zweier Spulensegmente 55 miteinander und mit der Signalverbindung 56 wie in B, C und D hin zu einer Verbindung aller anliegenden Spulensegmente 55 untereinander und mit der Signalverbindung 56 wie in E.

Natürlich sind auch andere Koppelelemente 70 vorstellbar. Beispielsweise könnten die drei Schaltelemente 71 auch in den Seiten eines Dreiecks angeordnet sein, dessen Ecken jeweils mit einem Spulensegment verbinden sind.

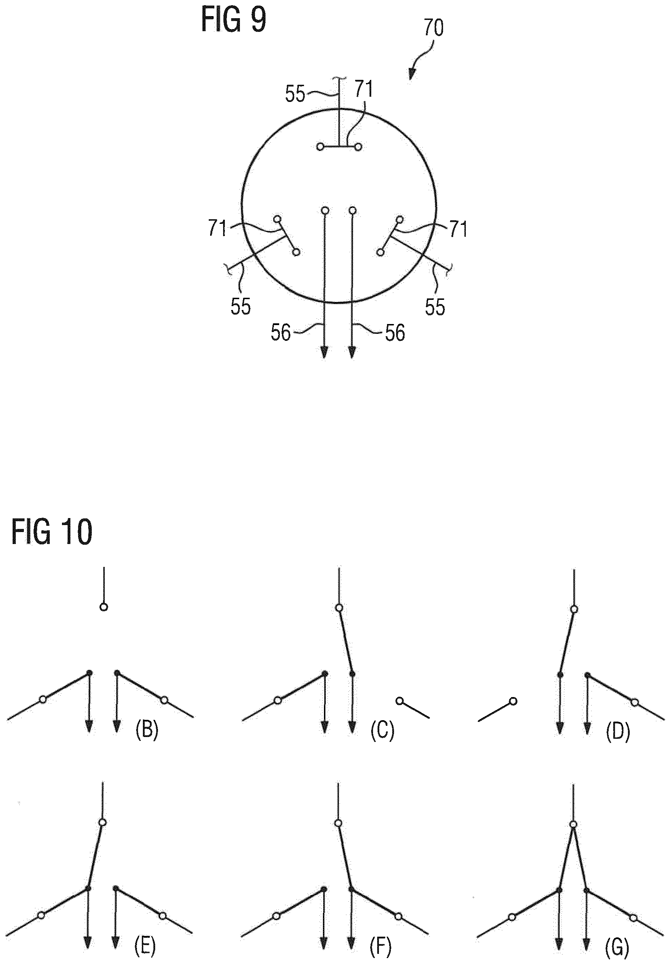

In Fig. 9 ist eine weitere mögliche Ausführungsform für ein Koppelelement 70 angegeben. Dabei ist jedes der drei am Koppelelement 70 angeschlossenen Spulensegmente 55 mit einem Schaltelement 71 versehen. Weiterhin weist das Koppelelement 70 zwei voneinander unabhängige Signalverbindungen 56 zu der Schaltmatrix 60 und/oder dem Magnetresonanztomographen 1 auf. Was die Ansteuerung der Schaltelemente 71 angeht, sei auf die Ausführungen zu Fig. 7 und 8 verwiesen.

In Fig. 10 sind unterschiedliche mögliche Schalteinstellungen der Schaltelemente 71 des Koppelelements aus Fig. 9 angegeben. Gegenüber dem Koppelement 70 aus Fig. 7 und 8 ermöglicht es das Koppelelement 70 in Fig. 9 und 10 durch die zwei Signalverbindungen 56, aus den anliegenden Spulenelementen 55 in Verbindung mit anderen Koppelelementen 70 und Spulensegmenten 55 zwei unmittelbar angrenzende Spulenwicklungen bereitzustellen und mit dem Magnetresonanztomographen 1 zu verbinden.

Auch die Lokalspulenmatrices 50 der Fig. 3 bis Fig. 10 ermöglichen es durch unterschiedliche Konfiguration der Koppelelemente 70, Spulenwicklungen mit unterschiedlichen Sensitivitätsbereichen bereitzustellen, mit denen es möglich ist, auf vorteilhafte Weise mit der gleichen Lokalspulenmatrix optimale Untersuchungen so unterschiedlicher Bereiche des Patienten wie Abdomen oder Handgelenk vorzunehmen.

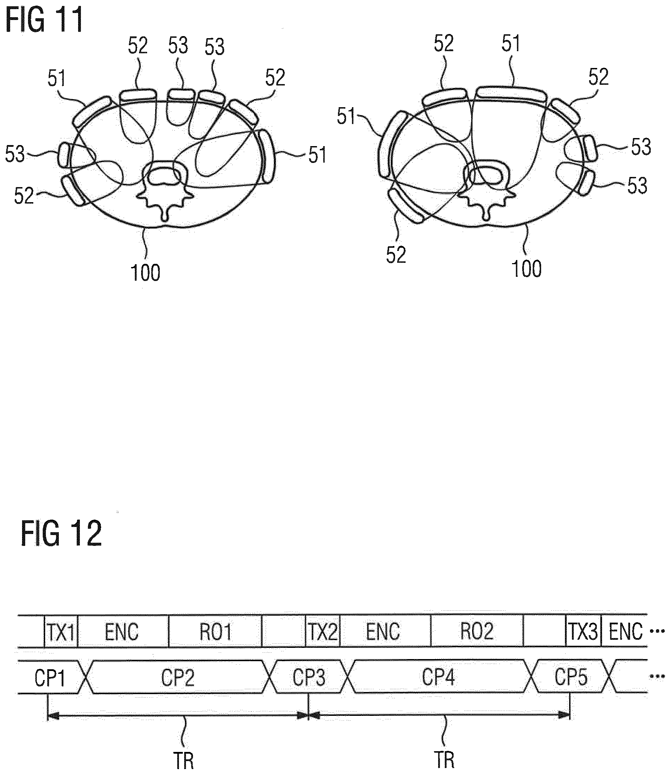

Fig. 11 zeigt eine schematische Darstellung von Sensitivitätsbereichen unterschiedlicher Konfigurationen der Lokalspulenmatrix 50 zur Ausführung des erfindungsgemäßen Verfahrens an einem Patienten 100. Dabei sind nur die Spulenwicklungen dargestellt, die bei der jeweiligen Konfiguration aktiv sind. Es kommen in dem Beispiel drei unterschiedliche Größen von Spulenwicklungen zur Verwendung: größte Spulenwicklungen 51, mittlere Spulenwicklungen 52 und kleinste Spulenwicklungen 53.

Die Spulenwicklungen können dabei beispielsweise wie in Fig. 2 dargestellt durch übereinanderliegende, unterschiedlich große Spulenwicklungen bereitgestellt werden, wobei jeweils in der Konfiguration nicht verwendete Spulenwicklungen nicht dargestellt sind. Die Auswahl der Spulenwicklungen erfolgt dabei beispielsweise über eine Schaltmatrix 60 oder Verstimmungseinrichtungen in den jeweiligen Spulenwicklungen.

Es ist aber auch denkbar, dass ein Verschalten der Spulensegmente zu größten Spulenwicklungen 51, mittleren Spulenwicklungen 52 und kleinsten Spulenwicklungen 53 mit Hilfe der Koppelelemente 70 erfolgt, wie es zu den Figuren 3 bis 10 im Detail dargestellt ist.

In Fig. 11 sind auch die Sensitivitätsbereiche der jeweiligen Spulenwicklungen dargestellt, die in den Körper des Patienten 100 hineinreichen. Dabei ist der Sensitivitätsbereich der größten Spulenwicklungen 51 am breitesten und tiefsten, während der Sensitivitätsbereich der kleinsten Spulenwicklungen 53 die kleinste laterale Ausdehnung und Tiefe hat. Dabei sollen vorzugsweise die Sensitivitätsbereiche, wie dargestellt, im Wesentlichen die ganze Körperoberfläche des Patienten unter den Spulen überdecken, sodass zwischen den einzelnen Spulenwicklungen keine Lücken bei der Erfassung der Magnetresonanzsignale oder bei Anregung der Kernspins auftreten.

Dabei weisen die beiden Konfigurationen der Fig. 11 unterschiedliche Sensitivitätsmuster auf, d.h. unterschiedliche Teilbereiche des Untersuchungsbereichs im Körper des Patienten 100 werden bei beiden Konfigurationen vorzugsweise durch unterschiedliche Spulenwicklungen mit unterschiedlichem Sensitivitätsbereich erfasst. Insbesondere sollte bei einer Datenerfassung für eine Abbildung jeder Teilbereich mindestens einmal durch zwei unterschiedliche Spulenwicklungen mit unterschiedlichen Sensitivitätsbereichen erfasst werden. Diese Erfassung mit unterschiedlichen Sensitivitätsbereichen wird auch als "Diversity" bezeichnet.

Insbesondere die Bildrekonstruktion mit einem "Compressed Sensing" profitiert von dieser räumlichen "Diversity" und erlaubt eine Beschleunigung der Bilderfassung durch in Summe weniger Auslesezyklen um bis zu einem Faktor 10. Dafür werden eine Anzahl von Spulensensitivitätsprofilen (CP2, CP4, CP6 in einem zufälligen Wiederholmuster für ihre Auslesezeit RO1, RO2..) und in ihrer Wiederholungsperiode TR umgeschaltet.

In Fig. 12 sind mehrere derartige Auslesezyklen in ihrer zeitlichen Abfolge dargestellt, die in Zusammenhang mit schematischen Ablaufdiagrammen des Verfahrens in Fig. 13 näher erläutert werden. Nach rechts ist die Zeit aufgetragen, die sich in einzelne Pulse-Trains oder Auslesezyklen unterteilt, die sich mit einer Periode TR wiederholen. Ein neuer Auslesezyklus beginnt jeweils mit einem als TX1, TX2 oder TX3 bezeichneten Anregungspuls zur Anregung der Kernspins in dem Untersuchungsbereich im Körper des Patienten. Dem schließt sich jeweils ein Encoding an, das üblicherweise durch einen Magnetfeldgradienten der Gradientenspulen gesteuert wird und den Kernspins eine räumliche Phasenzuordnung innerhalb einer Schicht oder Volumen aufprägt. Anschließend erfolgt ein Auslesen der Magnetresonanzsignale, die die Kernspins über den mit RO1, RO2 bezeichneten Zeitraum aussenden, indem die Hochfrequenz mit einer Spulenwicklung empfangen und mit Amplituden- und Phaseninformation aufgezeichnet wird. Dabei ist es denkbar, dass z.B. bei einem Multischichtverfahren unterschiedliche Schichten aufgrund eines Gradienten unterschiedliche Larmorfrequenzen aufweisen und so getrennt voneinander ausgelesen werden können. So ist es beispielsweise denkbar, dass in RO2 die Magnetresonanzsignale der mit TX1 angeregten Kernspins empfangen werden. Auf diese Weise können Pausen innerhalb eines Auslesezyklus, ausgenutzt werden, indem Magnetresonanzsignale einer anderen Schicht empfangen werden. Derartige Pausen können beispielsweise durch Relaxationszeiten der Kernspins erforderlich sein. Mit CP1, CP2, CP3, CP4 und CP5 sind dabei unterschiedliche Konfigurationen der Lokalspulenmatrix mit unterschiedlichen Sensitivitätsprofilen angezeigt, die dabei individuell für jeden Anregungspuls und jedes Auslesen angepasst und optimiert werden kann.

In einem Schritt S110 des Verfahrens aus Fig. 13 wird ein erster Anregungspulse gesendet, wobei eine erste Menge an ersten Spulenwicklungen resonant zur Frequenz des Anregungspulses ist. Die Resonanz kann beispielsweise durch das Einstellen von Verstimmungselementen oder durch das Zusammenschalten einer entsprechend lokalisierten Spulenwicklung aus einzelnen Spulensegmenten mittels der Koppelelemente erfolgen. Der Anregungspuls kann beispielsweise von der Hochfrequenzeinheit 22 des Magnetresonanztomographen 1 über die Körperspule 14, ein lokale Sendespule oder auch über Spulenwicklungen der Lokalspulenmatrix 50 gesendet werden. Dies entspricht beispielsweise dem Abschnitt TX1 der Fig. 12. Die resonanten Spulenwicklungen modifizieren dabei das B1-Feld des Anregungspulses in Ihrer Umgebung und erlauben so beispielsweise gezielt lokale Inhomogenitäten der Anregung der Kernspins auszugleichen. Der erzielte Effekt wird auch als B1-Shimming bezeichnet.

In einem Schritt S120 erfolgt ein Codieren der angeregten Kernspins mittels von der Gradientensteuerung 21 und den Gradientenspulen 12 erzeugten Feldgradienten.

In einem Schritt S130 werden Magnetresonanzsignale mittels einer zweiten Menge an ersten Spulenwicklungen und/oder zweiten Spulenwicklungen empfangen. In Fig. 12 entspricht dies dem Zeitabschnitt RO1. Dabei kann das Signal von den in TX1 angeregten Kernspins stammen, es ist aber auch denkbar, dass in RX1 Magnetresonanzsignale empfangen werden, die bereits in einer Anregungsphase vor TX1 in einem anderen Teilbereich des Untersuchungsbereichs angeregt wurden. Je nachdem wird die zweite Menge an Spulenwicklungen ausgewählt, beispielsweise so, dass deren Sensitivitätsbereich mit einem Anregungsbereich des dazugehörigen Anregungspulses entspricht. Werden in RO1 Kernspins ausgelesen, die in TX 1 angeregt wurden so kann die Konfiguration der Lokalspulenmatrix 50 möglicherweise gleich bleiben. Werden in RO1 aber Kernspins einer vor TX1 liegenden Anregung ausgelesen, so wird die Lokalspulenmatrix vorzugsweise in eine Konfiguration gebracht, deren Sensitivität der Anregungsverteilung während des entsprechenden Anregungspulses entspricht. So kann jeweils das beste Signal durch die konfigurierten Spulenwicklungen erzielt werden. Die Signale der Spulenwicklungen können dann einzeln oder mit anderen Signalen kombiniert nach einer Vorverstärkung und gegeben Falls Digitalisierung und/oder Frequenzumsetzung zur Auswertung an den Magnetresonanztomographen 1 zur Auswertung über eine Kabelverbindung oder drahtlos übermittelt werden.

In einem Schritt S140 wird ein zweiter Anregungspulses von der Hochfrequenzeinheit wie unter S110 beschrieben ausgesendet. Der Unterschied zu Schritt S110 besteht dabei zumindest darin, dass eine dritte Menge an ersten Spulenwicklungen resonant zur Frequenz des Anregungspulses ist. Unter einer Vielzahl von Anregungspulsen unterscheidet sich die dritte Menge der resonanten Spulenwicklungen von der bei vorherigen Anregungspulsen konfigurierten ersten Menge der resonanten Spulenwicklungen zumindest während eines Anregungspulses, vorzugsweise aber bei einer Vielzahl von Anregungspulsen. Beispielsweise kann die Menge der resonanten Spulenwicklungen bei einem Mehrschichtverfahren (engl. "Multi-Slice") für jede Schicht unterschiedlich sein.

In einem Schritt S150 erfolgt ein Codieren der in S140 angeregten Spins wie zuvor beschrieben mittels der Gradientenspulen 12, lediglich die Gradienten sind gegebenen Falls einem geänderten Anregungsbereich angepasst, der beispielsweise in einer anderen Schicht liegen kann.

In einem Schritt S160 werden Magnetresonanzsignale mittels einer vierten Menge an ersten Spulenwicklungen und/oder zweiten Spulenwicklungen empfangen. Auch hier gilt das unter S130 dargelegte. Erfindungsgemäß unterscheidet sich die vierte Menge der Spulenwicklungen von der zweiten Menge der Spulenwicklungen.

Das Verfahren der Fig. 13 erlaubt auf vorteilhafte Weise durch die flexible Konfigurierbarkeit der Lokalspulenmatrix einen schnellen Wechsel der Hochfrequenzeigenschaften und damit eine Optimierung der Anregung auch für einzelne individuelle Pulse einer Bilderfassung.

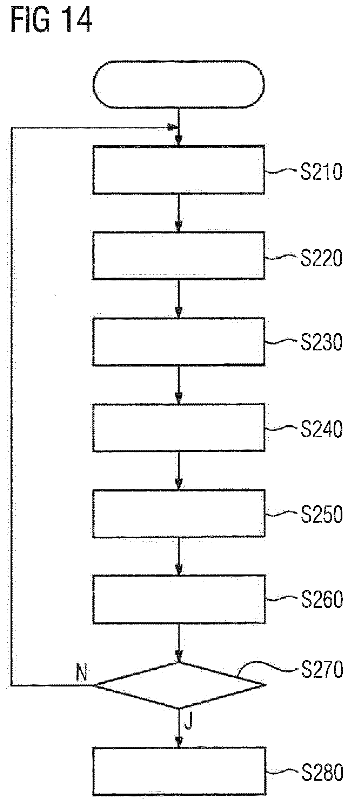

In Fig. 14 ist eine Ausführungsform eines erfindungsgemäßen Verfahrens dargestellt, das ein Beispiel angibt, wie die Eigenschaften der Lokalspulenmatrix 50 empfangsseitig und nachfolgend bei der Bildrekonstruktion genutzt werden können. Dabei kann das Verfahren der Fig. 14 auch mit dem Verfahren der Fig. 13 kombiniert werden, indem die speziellen Eigenschaften der Lokalspulenmatrix bei der Anregung angewendet werden.

In einem Schritt S210 wird ein erster Anregungspuls gesendet.

Dies kann wie zu Fig. 13 unter S110 beschrieben geschehen, oder auch ohne resonante Einstellung von Lokalspulen, beispielsweise mit einer Körperspule 14.

In einem Schritt 220 werden die Kernspins, wie bereits zu S120 beschrieben mittels Gradientenspulen kodiert.

In einem Schritt S230 werden Magnetresonanzsignale mittels einer zweiten Menge an ersten Spulenwicklungen und/oder zweiten Spulenwicklungen empfangen. Auch hier gilt das zu S130 angeführte. Vorzugsweise sind aber die Sensitivitätsbereiche zumindest einiger der Spulenwicklungen im Untersuchungsbereich unterschiedlich groß bzw. weist ein unterschiedlich großes Volumen auf, wie es beispielsweise auf der linken Seite von Fig. 11 dargestellt ist. Die bei Schritt S230 empfangenen Daten weisen dadurch in sich eine räumliche "Diversity" auf, die nachfolgend für eine Bildrekonstruktion mittels "Compressed Sensing" von Vorteil ist.

In einem Schritt S240 wird ein zweiter Anregungspuls gesendet. Dies kann wie unter S210 beschrieben erfolgen oder auch gemäß der Beschreibung zu S140 in Fig. 13, wenn eine Anregungsoptimierung erfolgen soll.

In einem Schritt 250 werden die Kernspins, wie bereits zu S120, S150 und S220 beschrieben, mittels Gradientenspulen 12 kodiert.

In einem Schritt S260 werden Magnetresonanzsignale mittels einer vierten Menge an ersten Spulenwicklungen und/oder zweiten Spulenwicklungen empfangen. Der Schritt zeichnet sich gegenüber S160 dadurch aus dass die zweite Menge ungleich der vierten Menge ist. Das heißt, die zweite Menge und die vierte Menge unterscheiden sich zumindest in einer ersten oder zweiten Spulenwicklung, sodass sich die Sensitivitätsbereiche der beiden Mengen unterscheiden. Die Unterscheidung betrifft dabei nicht nur unterschiedliche Vereinigungsmengen aller Sensitivitätsbereiche der Spulenwicklungen der vierten Menge, sondern im Sinne der Erfindung ist es bereits hinreichend, wenn dabei ein Teilbereich von einer anderen Spulenwicklung mit unterschiedlichem Sensitivitätsbereich als bei der zweiten Menge erfasst wird. Ein Beispiel kann der Fig. 11 entnommen werden, wobei die linke Darstellung beispielsweise die zweite Menge an Spulenwicklungen darstellt und die rechte Darstellung die vierte Menge an Spulenwicklungen.

In einem Schritt S270 prüft der Magnetresonanztomograph, ob ausreichend Magnetresonanzsignale für eine Bildrekonstruktion erfasst wurden. Wenn nicht, werden die Schritte des Sendens (S210, 240), Kodierens (S220, S250) und Empfangens (S230, S260) mit jeweils unterschiedlichen zweiten Mengen und vierten Mengen wiederholt. Hierbei ist anzumerken, dass erfindungsgemäß stets eine Wiederholung der genannten Schritte erfolgt.

Sind ausreichend Daten für eine Bildrekonstruktion erfasst erzeugt der Magnetresonanztomograph 1 oder auch ein externer Computer in einem Schritt S280 eine Abbildung in Abhängigkeit von den von der Mehrzahl der zweiten Mengen und der vierten Mengen empfangenen Magnetresonanzsignalen. Dabei kann eine ausreichende Menge aufgrund der "Diversity" der erfassten Magnetresonanzsignale und des verwendeten Rekonstruktionsverfahrens um bis zu einem Faktor 10 geringer sein als bei einer herkömmlichen Bildrekonstruktion. Erfindungsgemäß kommt mit der Lokalspulenmatrix und dem erfindungsgemäßen Verfahren zur Signalerfassung Compressed Sensing bei der Bildrekonstruktion zum Einsatz.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der durch die Ansprüche definiert wird.

## Patentansprüche

1. Verfahren zur Bilderfassung mit einem Magnetresonanztomographen mit einer Lokalspulenmatrix (50),
wobei die Lokalspulenmatrix (50) eine Mehrzahl an ersten Spulenwicklungen und zweiten Spulenwicklungen aufweist und ausgelegt ist, bei einer Magnetresonanztomographie einen vorbestimmten Bereich eines in Nachbarschaft zu der Lokalspulenmatrix (50) angeordneten Patienten mit auswählbaren unterschiedlich großen Sensitivitätsbereichen erfassen und/oder anregen zu können,
wobei die Lokalspulenmatrix (50) eine Mehrzahl an zweiten Spulenwicklungen aufweist, die jeweils erste Spulenwicklungen aufweisen, deren Sensitivitätsbereich Teilmenge des Sensitivitätsbereichs der jeweiligen zweiten Spulenwicklung ist, wobei eine erste Spulenwicklung aus der Mehrzahl der ersten Spulenwicklungen jeweils einen ersten Sensitivitätsbereich aufweist und eine zweite Spulenwicklung aus der Menge der zweiten Spulenwicklungen jeweils einen zweiten Sensitivitätsbereich aufweist, wobei der erste Sensitivitätsbereich eine Teilmenge des zweiten Sensitivitätsbereiches ist,
wobei die Lokalspulenmatrix (50) eine Steuerung und die ersten Spulenwicklungen Verstimmungselemente in Signalverbindung mit der Steuerung aufweist,
wobei das Verfahren die Schritte aufweist:
(S210) Senden eines ersten Anregungspulses;
(S220) Kodieren der Spins mittels Gradientenspulen;
(S230) Empfangen von Magnetresonanzsignalen mittels einer zweiten Menge an ersten Spulenwicklungen und/oder zweiten Spulenwicklungen;
(S240) Senden eines zweiten Anregungspulses;
(S250) Kodieren der Spins mittels der Gradientenspulen;
(S260) Empfangen von Magnetresonanzsignalen mittels einer vierten Menge an ersten Spulenwicklungen und/oder zweiten Spulenwicklungen, wobei die zweite Menge ungleich der vierten Menge ist,
wobei eine Vereinigungsmenge der Sensitivitätsbereiche der zweiten Menge und eine Vereinigungsmenge der Sensitivitätsbereiche der vierten Menge die Oberfläche des Untersuchungsbereichs im Wesentlichen abdeckt,
wobei das Verfahren weiterhin die Schritte aufweist:
(S270) Wiederholen der Schritte des Sendens (S210, S240), Kodierens (S220, S250) und Empfangens (S230, S260) mit jeweils unterschiedlichen zweiten Mengen und vierten Mengen;
(S290) Erzeugen einer Abbildung in Abhängigkeit von den von der Mehrzahl der zweiten Mengen und der vierten Mengen empfangenen Magnetresonanzsignalen,
wobei das Erzeugen der Abbildung in Schritt (S290) ein Compressed Sensing Verfahren anwendet.

2. Verfahren zur Bilderfassung mit einem Magnetresonanztomographen mit einer Lokalspulenmatrix,
wobei die Lokalspulenmatrix (50)
eine Mehrzahl an Spulenwicklungen aufweist und ausgelegt ist, bei einer Magnetresonanztomographie einen vorbestimmten Bereich eines in Nachbarschaft zu der Lokalspulenmatrix (50) angeordneten Patienten mit auswählbaren unterschiedlich großen Sensitivitätsbereichen erfassen und/oder anregen zu können,
wobei die Lokalspulenmatrix mehrere Koppelelemente (70), eine Mehrzahl an Spulensegmenten (55) und eine Steuerung in Signalverbindung mit den Koppelelementen (70) aufweist, wobei die Koppelelemente (70) jeweils mit mindestens zwei Spulensegmenten (55) einer Spulenwicklung in Signalverbindung stehen,
wobei die Koppelelemente ausgelegt sind, flexibel unterschiedliche Muster an ersten und zweiten Spulenwicklungen bereitzustellen,
wobei die Steuerung ausgelegt ist, die Spulensegmente (55) durch Aktivieren eines ersten Schaltzustandes der Koppelelemente (70) zu einer ersten Spulenwicklung und Aktivieren eines zweiten Schaltzustandes der Koppelelemente (70) zu einer zweiten Spulenwicklung zu verschalten, wobei die erste Spulenwicklung eine kleinere umschlossene Fläche aufweist als die zweite Spulenwicklung,
wobei das Verfahren die Schritte aufweist:
(S210) Senden eines ersten Anregungspulses;
(S220) Kodieren der Spins mittels Gradientenspulen;
(S230) Empfangen von Magnetresonanzsignalen mittels einer zweiten Menge an ersten Spulenwicklungen und/oder zweiten Spulenwicklungen;
(S240) Senden eines zweiten Anregungspulses;
(S250) Kodieren der Spins mittels der Gradientenspulen;
(S260) Empfangen von Magnetresonanzsignalen mittels einer vierten Menge an ersten Spulenwicklungen und/oder zweiten Spulenwicklungen, wobei die zweite Menge ungleich der vierten Menge ist,
wobei eine Vereinigungsmenge der Sensitivitätsbereiche der zweiten Menge und eine Vereinigungsmenge der Sensitivitätsbereiche der vierten Menge die Oberfläche des Untersuchungsbereichs im Wesentlichen abdeckt,
wobei das Verfahren weiterhin die Schritte aufweist:
(S270) Wiederholen der Schritte des Sendens (S210, S240), Kodierens (S220, S250) und Empfangens (S230, S260) mit jeweils unterschiedlichen zweiten Mengen und vierten Mengen;
(S290) Erzeugen einer Abbildung in Abhängigkeit von den von der Mehrzahl der zweiten Mengen und der vierten Mengen empfangenen Magnetresonanzsignalen,
wobei das Erzeugen der Abbildung in Schritt (S290) ein Compressed Sensing Verfahren anwendet.

3. Verfahren nach Anspruch 1 oder 2, wobei die Lokalspulenmatrix (50) eine Kombinationsmatrix mit ersten Signalanschlüssen und zweiten Signalanschlüssen und eine Steuerung in Signalverbindung mit der Kombinationsmatrix aufweist, wobei die ersten Signalanschlüsse mit der Mehrzahl der Spulenwicklungen in Signalverbindung steht, wobei die Kombinationsmatrix ausgelegt ist, ein Ausgangssignal in eine durch die Steuerung einstellbarer Abhängigkeit von einer Vielzahl an ersten Signalanschlüssen anliegenden Eingangssignalen an einem zweiten Signalanschluss auszugeben,
wobei die Kombinationsmatrix in den Schritten des Empfangens (S230, S260) in Abhängigkeit von den Magnetresonanzsignalen der zweiten Mengen bzw. der vierten Mengen jeweils Ausgangssignale bereitstellt, deren Anzahl kleiner ist als die Anzahl der Spulenwicklungen in den zweiten Mengen bzw. vierten Mengen.

4. Verfahren nach einem der vorhergehenden Ansprüche, wobei in wiederholten Schritten des Empfangens (S230, S260) sich zweite Mengen und vierte Mengen mit jeweils gleichen Sensitivitätsbereichen zufällig ohne Periodizität wiederholen.

## Claims

1. Method for image acquisition with a magnetic resonance tomography unit with a local coil matrix,
wherein the local coil matrix (50) has a plurality of first and second coil windings and is designed, in the case of magnetic resonance tomography, to be able to acquire and/or excite a predetermined region of a patient arranged in the vicinity of the local coil matrix (50) with selectable differently sized sensitivity ranges,
wherein the local coil matrix (50) has a plurality of second coil windings, which each have first coil windings, the sensitivity range of which is a subset of the sensitivity range of the respective second coil winding,
wherein a first coil winding out of the plurality of the first coil windings has a first sensitivity range in each case and a second coil winding out of the set of second coil windings has a second sensitivity range in each case, wherein the first sensitivity range is a subset of the second sensitivity range,
wherein the local coil matrix (50) has a controller and the first coil windings have detuning elements in signal connection with the controller,
wherein the method has the steps:
(S210) transmitting a first excitation pulse;
(S220) encoding the spins by means of gradient coils;
(S230) receiving magnetic resonance signals by means of a second set of first coil windings and/or second coil windings;
(S240) transmitting a second excitation pulse;
(S250) encoding the spins by means of the gradient coils;
(S260) receiving magnetic resonance signals by means of a fourth set of first coil windings and/or second coil windings,
wherein the second set is different from the fourth set,
wherein a set union of the sensitivity ranges of the second set and a set union of the sensitivity ranges of the fourth set substantially covers the surface of the examination region,
wherein the method further has the steps:
(S270) repeating the steps of transmitting (S210, S240), encoding (S220, S250) and receiving (S230, S260) with different second sets and fourth sets in each case;
(S290) generating an image in dependence on the magnetic resonance signals received from the plurality of second sets and fourth sets,
wherein the generation of the image in step (S290) uses a compressed sensing method.

2. Method for image acquisition with a magnetic resonance tomography unit with a local coil matrix,
wherein the local coil matrix (50)
has a plurality of coil windings and is designed to be able, during magnetic resonance tomography, to acquire and/or excite a predetermined region of a patient arranged in the vicinity of the local coil matrix (50) with selectable differently sized sensitivity ranges,
wherein the local coil matrix has a plurality of coupling elements (70), a plurality of coil segments (55) and a controller in signal connection with the coupling elements (70), wherein the coupling elements (70) are in each case in signal connection with at least two coil segments (55) of a coil winding,
wherein the coupling elements are designed to provide different patterns of first and second coil windings in a flexible manner,
wherein the controller is designed to interconnect the coil segments (55) to a first coil winding by activating a first switching state of the coupling element (70) or coupling elements (70) and to a second coil winding by activating a second switching state of the coupling element (70) or coupling elements (70), wherein the first coil winding has a smaller enclosed area than the second coil winding,
wherein the method has the steps:
(S210) transmitting a first excitation pulse;
(S220) encoding the spins by means of gradient coils;
(S230) receiving magnetic resonance signals by means of a second set of first coil windings and/or second coil windings;
(S240) transmitting a second excitation pulse;
(S250) encoding the spins by means of the gradient coils;
(S260) receiving magnetic resonance signals by means of a fourth set of first coil windings and/or second coil windings,
wherein the second set is different from the fourth set,
wherein a set union of the sensitivity ranges of the second set and a set union of the sensitivity ranges of the fourth set substantially covers the surface of the examination region,
wherein the method further has the steps:
(S270) repeating the steps of transmitting (S210, S240), encoding (S220, S250) and receiving (S230, S260) with different second sets and fourth sets in each case;
(S290) generating an image in dependence on the magnetic resonance signals received from the plurality of second sets and fourth sets,
wherein the generation of the image in step (S290) uses a compressed sensing method

3. Method according to claim 1 or 2, wherein the local coil matrix (50) has a combination matrix with first signal terminals and second signal terminals and a controller in signal connection with the combination matrix, wherein the first signal terminals are in signal connection with the plurality of coil windings, wherein the combination matrix is designed to emit an output signal in a dependence adjustable by the controller on a multiplicity of input signals applied to first signal terminals at a second signal terminal, wherein, in the receiving steps (S230, S260), the combination matrix provides, in each case in dependence on the magnetic resonance signals of the second sets or the fourth sets, output signals the number of which is smaller than the number of coil windings in the second sets or fourth sets.

4. Method according to one of the preceding claims, wherein, in repeated receiving steps (S230, S260), second sets and fourth sets with in each case equal sensitivity ranges are repeated randomly without periodicity.

## Revendications

1. Procédé de prise d'image par un tomodensitomètre à résonnance magnétique ayant une matrice (50) de bobine locale, dans lequel la matrice (50) de bobine locale a une pluralité de premiers enroulements de bobine et de deuxièmes enroulements de bobine et est conçue pour, lors d'une tomodensitométrie par résonnance magnétique, à pouvoir saisir et/ou à exciter, avec des plages de sensibilité de grandeur différente pouvant être sélectionnées, une partie définie à l'avance d'un patient, disposée au voisinage de la matrice (50) de bobine locale,
dans lequel la matrice (50) de bobine locale a une pluralité de deuxièmes enroulements de bobine, qui ont respectivement des premiers enroulements de bobine, dont la plage de sensibilité est un sous-ensemble de la plage de sensibilité du deuxième enroulement respectif de bobine, dans lequel un premier enroulement de bobine de la pluralité des premiers enroulements de bobine a respectivement une première plage de sensibilité, et un deuxième enroulement de bobine de l'ensemble des deuxièmes enroulements de bobine a respectivement une deuxième plage de sensibilité, dans lequel la première plage de sensibilité est un sous-ensemble de la deuxième plage de sensibilité,
dans lequel la matrice (50) de bobine locale a une commande et a , en liaison de signal avec la commande, des éléments pour désaccorder les premiers enroulements de bobine,
dans lequel le procédé a les stades :
(S210) émission d'une première impulsion d'excitation ;
(S220) codage des spins au moyen d'impulsions de gradient ;
(S230) réception de signaux de résonnance magnétique au moyen d'un deuxième ensemble de premiers enroulements de bobine et/ou de deuxièmes enroulements de bobine ;
(S240) envoi d'une deuxième impulsion d'excitation ;
(S250) codage des spins au moyen des impulsions de gradient ;
(S260) réception de signaux de résonnance magnétique au moyen d'un quatrième ensemble de premiers enroulements de bobine et/ou de deuxièmes enroulements de bobine, le deuxième ensemble étant différent du quatrième ensemble,
dans lequel une réunion des plages de sensibilité du deuxième ensemble et une réunion des plages de sensibilité du quatrième ensemble recouvre sensiblement la surface de la partie à examiner,
dans lequel le procédé a en outre les stades :
(S270) répétition des stades de l'émission (S210, S240) du codage (S220, S250) et de la réception (S230, S260) avec des deuxièmes ensembles et quatrièmes ensembles respectivement différents ; (S290) production d'une reproduction en fonction des signaux de résonnance magnétique reçus par la pluralité des deuxièmes ensembles et des quatrièmes ensembles,
dans lequel la production de la reproduction au stade (S290) applique un procédé compressed sensing.

2. Procédé de saisie d'image par un tomographe à résonnance magnétique ayant une matrice de bobine locale,
dans lequel la matrice (50) de bobine locale
a une pluralité d'enroulements de bobine et est conçue pour pouvoir saisir et/ou à exciter, avec des plages de sensibilité de grandeur différente pouvant être sélectionnées, une partie définie à l'avance d'un patient, disposée au voisinage de la matrice (50) de bobine locale,
dans lequel la matrice de bobine locale a une pluralité d'éléments (70) de couplage, une pluralité de segments (55) de bobine et une commande en liaison de signal avec les éléments (70) de couplage, dans lequel les éléments (70) de couplage sont en liaison de signal respectivement avec au moins deux segments (55) de bobine d'un enroulement de bobine,
dans lequel les éléments de couplage sont conçus pour mettre à disposition de manière souple des motifs différents des premiers et deuxièmes enroulements de bobine,
dans lequel la commande est conçue pour relier les segments (55) de bobine par activation d'un premier état de commutation des éléments (70) de couplage à un premier enroulement de bobine et, par activation d'un deuxième état de commutation des éléments (70) de couplage, à un deuxième enroulement de bobine, le premier enroulement de bobine ayant une surface entourée plus petite que le deuxième enroulement de bobine,
dans lequel le procédé a les stades :
(S210) émission d'une première impulsion d'excitation ;
(S220) codage des spins au moyen d'impulsions de gradient ;
(S230) réception de signaux de résonnance magnétique au moyen d'un deuxième ensemble de premiers enroulements de bobine et/ou de deuxièmes enroulements de bobine ;
(S240) émission d'une deuxième impulsion d'excitation ;
(S250) codage des spins au moyen des impulsions de gradient ;
(S260) réception de signaux de résonnance magnétique au moyen d'un quatrième ensemble de premiers enroulements de bobine et/ou de deuxièmes enroulements de bobine, le deuxième ensemble étant différent du quatrième ensemble,
dans lequel une réunion des plages de sensibilité du deuxième ensemble et une réunion des plages de sensibilité du quatrième ensemble recouvre sensiblement la surface de la partie à examiner,
dans lequel le procédé a en outre les stades :
(S270) répétition des stades de l'émission (S210, S240), du codage (S220, S250) et de la réception (S230, S260) avec des deuxièmes ensembles et quatrièmes ensembles respectivement différents ;
(S290) production d'une reproduction en fonction des signaux de résonnance magnétique reçus par la pluralité des deuxièmes ensembles et des quatrièmes ensembles, dans lequel dans lequel la production de la reproduction au stade (S290) applique un procédé compressed sensing.

3. Procédé suivant la revendication 1 ou 2, dans lequel la matrice (50) de bobine locale a une matrice de combinaison ayant des premières bornes de signal et des deuxièmes bornes de signal et une commande en liaison de signal avec la matrice de combinaison, dans lequel les premières bornes de signal sont en liaison de signal avec la pluralité des enroulements de bobine, dans lequel la matrice de combinaison est constituée pour donner, à une deuxième borne de signal, un signal de sortie, en fonction pouvant être réglée par la commande, d'une pluralité de signaux d'entrée s'appliquant aux premières bornes de signal,
dans lequel la matrice de combinaison, dans les stades de la réception (S230, S260), met à disposition, en fonction des signaux de résonnance magnétique du deuxième ensemble et respectivement du quatrième ensemble, respectivement des signaux de sortie, dont le nombre est plus petit que le nombre des enroulements de bobine dans les deuxièmes ensembles et respectivement quatrièmes ensembles.

4. Procédé suivant l'une des revendications précédentes, dans lequel, dans les stades répétés de la réception (S230, S260) des deuxièmes ensembles et quatrièmes ensembles ayant de mêmes plages de sensibilité respectivement, se répètent aléatoirement sans périodicité.
